# EUROPÄISCHE PATENTSCHRIFT

(11) **EP 4 113 180 B1**
(45) Veröffentlichungstag und Bekanntmachung des Hinweises auf die Patenterteilung: **01.10.2025**
(21) Anmeldenummer: 22177161.1
(22) Anmeldetag: 03.06.2022
(51) Int. Cl.: G02B 6/12, B23K 26/0622, B23K 26/082, B23K 26/08, B23K 26/12, B23K 26/364, B23K 26/402, B23K 101/40, B23K 103/00, B81C 1/00

(54) **VERFAHREN ZUM BILDEN VON FREISTEHENDEN MIKROSTRUKTUREN AN EINEM DIAMANT-KRISTALL**
METHOD FOR FORMING FREE-STANDING MICROSTRUCTURES ON A DIAMOND CRYSTAL
PROCÉDÉ DE FORMATION DES MICROSTRUCTURES AUTOPORTANTES SUR UN CRISTAL DE DIAMANT

(30) Priorität: 02.07.2021 DE 102021206956
(43) Veröffentlichungstag der Anmeldung: 04.01.2023
(73) Patentinhaber: Q.ant GmbH, 70565 Stuttgart (DE)
(72) Erfinder: RÖLVER, Dr. Robert, 75365 Calw (DE); HENGESBACH, Dr.-Ing. Stefan, 70469 Stuttgart (DE); FÖRTSCH, Dr. Michael, 91522 Ansbach (DE)
(74) Vertreter: DREISS Patentanwälte PartG mbB

(56) Entgegenhaltungen:
- GB-A- 2 527 422
- MICHAEL J. BUREK ET AL: "Free-Standing Mechanical and Photonic Nanostructures in Single-Crystal Diamond", NANO LETTERS, vol. 12, no. 12, 12 December 2012 (2012-12-12), US, pages 6084 - 6089, XP055368773, ISSN: 1530-6984, DOI: 10.1021/nl302541e

## Beschreibung

Die vorliegende Erfindung betrifft das Bilden von insbesondere optisch nutzbaren Mikrostrukturen, beispielsweise von optisch nutzbaren Wellenleiterstrukturen, an einem Diamant-Kristall (einem Diamant-Einkristall).

In dem Artikel "Free-Standing Mechanical and Photonic Nanostructures in Single-Crystal Diamond", Michael J. Burek et al., Nano Letters, Bd. 12, Nr. 12, Dez. 2012 wird ein Verfahren zum Herstellen von freistehenden Nanosturkturen in einem einkristallinen Diamanten beschrieben. Zu diesem Zweck wird eine dreidimensionale Herstellungstechnik verwendet, die auf anisotropem Plasmaätzen unter einem schiefen Winkel zur Oberfläche der Probe beruht. Hierbei wird zunächst eine Ätzmaske auf eine Oberfläche eines Diamantkristalls aufgebracht und ein Muster dieser Ätzmaske wird durch das anisotrope Plasmaätzen in den Diamantkristall übertragen, d.h. die Oberfläche des Diamantkristalls wird durch Abtragen von Material strukturiert. Hierbei können zwei Gräben erzeugt werden, welche die Seitenwände einer in dem ersten Schritt erzeugten Struktur bilden. In einem nachfolgenden zweiten Schritt wird das anisotrope Ätzen durchgeführt, wodurch eine freistehende Struktur mit dreieckigem Querschnitt erzeugt wird, die sich von der zuvor gebildeten Struktur mit den parallel ausgerichteten Seitenwänden unterscheidet. In einem nachfolgenden Schritt wird die zurückgebliebene Ätzmaske entfernt. Mit diesem Verfahren können nur freistehende Strukturen erzeugt werden, die eine dreieckige Querschnittsgeometrie aufweisen.

Für die Bildung von Mikrostrukturen, beispielsweise von Wellenleiterstrukturen, in optischen Kristallen gibt es unterschiedliche Ansätze. Ein Ansatz besteht darin, die Wellenleiter durch Brechungsindexmodifikation in den optischen Kristall einzuschreiben, wie dies beispielsweise in dem Artikel "High-repetition-rate femtosecond-laser micromachining of low-Ioss optical-lattice-like-waveguides in lithium niobate", T. Piromjitpong et al., Proc. of SPIE Vol. 10684 (2018) beschrieben ist. Ein weiterer Ansatz besteht darin, die Mikrostrukturen durch Laserablation herzustellen.

Beide Ansätze werden in dem Artikel "Optical waveguides in crystalline dielectric materials produced by femtosecond-laser micromachining", Feng Chen et. al., Laser Photonics Rev. 8, No. 2, 2014 beschrieben. Dort ist unter anderem angegeben, dass Stegwellenleiter durch Laserablation hergestellt werden können, indem Rillen in das Substrat eingebracht werden, zwischen deren Seitenwänden der Stegwellenleiter ausgebildet wird. Dort ist auch beschrieben, dass ein Nachteil der auf diese Weise hergestellten Stegwellenleiter darin besteht, dass bei der Laserablation mit Femtosekunden-Laserpulsen raue Seitenwände gebildet werden, welche die Qualität des Stegwellenleiters reduzieren und dessen Verluste erhöhen.

In der EP 0 803 747 A2 ist ein Verfahren zum Herstellen einer Subtrats beschrieben, das mit einem optischen Wellenleiter in Form eines Stegwellenleiters versehen ist. Der Stegwellenleiter wird durch Laserablation hergestellt, beispielsweise unter Verwendung eines Excimer-Lasers bei Wellenlängen zwischen 150 nm und 300 nm und Pulsdauern im Bereich von Nanosekunden. Der Laserstrahl kann zu diesem Zweck auf eine Oberfläche des Substrats ausgerichtet und über das Substrat bewegt bzw. gescannt werden. Die optische Achse des Laserstrahls ist hierbei vertikal zur Oberfläche des Substrats ausgerichtet. Der Stegwellenleiter sollte ein möglichst rechteckiges Querschnitts-Profil aufweisen, um Lichtverluste zu vermeiden.

Die Herstellung von Mikrostrukturen in einem Diamant-Kristall wird im Vergleich zu Kristallen aus anderen Materialien dadurch erschwert, dass die Kohlenstoff-Atome eine extrem hohe Bindungsenergie aufweisen und daher die Laserablationsschwelle bei der Verwendung von gepulsten (UV-)Lasern mit 2 J/cm² sehr hoch liegt. Zur Mikrostrukturierung von Diamant werden daher typischerweise Ätzprozesse eingesetzt, beispielsweise reaktives Ionenätzen, vgl. den Artikel "Inverse Designed Diamond Photonics", C. Dori et al., nature communications (2019) 10:3309, den Artikel "Development of all-diamond scanning probes based on Faraday cage angled etching techniques" von C. Giese et al., MRS Advances, Vol. 5, pp. 1899-1907 (2020), in dem beim reaktiven Ionenätzen ein RF Bias-Käfig verwendet wird, oder den Artikel "Anisotropic diamond etching through thermochemical reaction between Ni and diamond in high-temperature water vapour", M. Nagai et al., Scientific Reports (2018) 8:6687, in dem ein Ätzprozess mit Hilfe einer thermochemischen Reaktion zwischen Ni und Diamant in Hochtemperatur-Wasserdampf beschrieben wird.

Aufgrund der begrenzten Interaktionstiefen der für die Laserablation üblicherweise verwendeten fs-Laser sind bisherige Versuche zur Mikrostrukturierung von Diamant-Kristallen durch Laserablation auf die Herstellung von laserinduzierten periodischen Oberflächenstrukturen mit Strukturgrößen von typischerweise weniger als 200 nm begrenzt, vgl. beispielsweise den Artikel "Photonic structures in diamond based on femtosecond UV laser induced periodic surface structuring (LIPSS)", E. Granados et al., Optics Express, Vol. 25, No. 13, p.15330.

In dem Artikel "Nonlinear photooxidation of diamond surface exposed to femtosecond laser pulses", V. V. Kononenko et al., Laser Phys. Lett. 12 (2014) 096101, wird beschrieben, dass bei der Bestrahlung von Diamant mit fs-Laserpulsen eine photoinduzierte Oxidation des Kohlenstoffs des Diamant-Kristalls erfolgt, bei der volatile Ätzprodukte wie CO oder CO₂ gebildet werden. In dem Artikel "Nonlinear photooxidation of diamond surface exposed to femtosecond laser pulses", V. I. Konov, Laser Physics Letters 12 (2015), 096101, ist u.a. beschrieben, dass die Desorptionsrate von Kohlenstoff-Spezies bei der Fotooxidation proportional zur Wurzel der induzierten Plasma-Dichte ist.

Bei den optisch nutzbaren Mikrostrukturen, die in einen Diamant-Kristall eingeschrieben werden, kann es sich beispielsweise um Wellenleiterstrukturen oder um Geometrien zum Sammeln von Licht handeln. Insbesondere wenn der Diamant-Kristall mit Farbzentren dotiert ist, beispielsweise mit NV("nitrogen vacancy")-Zentren, kann dieser zur Realisierung von Quanten-Sensoren, für die Quanten-Kryptographie bis hin zur Realisierung von Quanten-Computern verwendet werden. In allen diesen Anwendungen dient die Fluoreszenz der Farbzentren als Informationsträger, der effizient ausgelesen werden muss. Bei diamant-basierten Quanten-Sensoren können lichtleitende Mikrostrukturen in dem Diamant-Kristall dazu beitragen, das Signal-zu-Rausch-Verhältnis beim Auslesen zu erhöhen und damit die Empfindlichkeit der Quanten-Sensoren zu verbessern. Beispielsweise können die Mikrostrukturen bei Diamant-Kristallen, die mit Farbzentren dotiert sind, dazu verwendet werden, um einerseits eine optimale optische Anregungsdichte von Anregungslicht bei einer Anregungs-Wellenlänge (bei der Verwendung von NV-Zentren beispielsweise zwischen 510-550 nm) und andererseits eine optimales Sammeln des durch das Anregungslicht erzeugten Fluoreszenzlichts (beispielsweise bei Fluoreszenz-Wellenlängen zwischen 620 nm-680 nm) zu ermöglichen, z.B. um das Fluoreszenzlicht einem Detektor zuzuführen. Weitere Anwendungen der Mikrostrukturierung von Diamant-Kristallen sind die präzise Laserbearbeitung und Strukturierung von Diamant-Bauteilen wie Laserfenstern, Diamant-basierten Hochtönern in Lautsprechern oder Diamant-Bauteilen für die Wärmeabfuhr in elektronischen Schaltungen und Schaltanlagen.

Zur Bildung derartiger und anderer Mikrostrukturen bieten sich direkt schreibende Laserablationsverfahren an. Die präzise Bildung von Mikrostrukturen, d.h. von Strukturen mit Strukturbreiten im Mikrometerbereich, durch Laserablation in einem Diamant-Kristall ist aufgrund der weiter oben beschriebenen Problematik bislang jedoch nicht möglich. Insbesondere ist kein Verfahren zur dreidimensionalen Strukturierung eines Diamant-Kristalls bekannt, bei dem freistehende Mikrostrukturen bzw. Wellenleiterstrukturen in dem Diamant-Kristall gebildet werden.

### Aufgabe der Erfindung

Der Erfindung liegt die Aufgabe zugrunde, ein Verfahren zur Bildung von freistehenden Mikrostrukturen, insbesondere mit freistehenden Wellenleiterstrukturen, in einem Diamant-Kristall bereitzustellen.

### Gegenstand der Erfindung

Diese Aufgabe wird gelöst durch ein Verfahren zum Bilden mindestens einer freistehenden Mikrostruktur, insbesondere einer freistehenden Wellenleiterstruktur, an einem Diamant-Kristall, das folgende Schritte umfasst: Strukturieren einer Oberfläche des Diamant-Kristalls durch Abtragen von Material zur Ausbildung von mindestens zwei Gräben, deren benachbarte Seitenwände die Seitenwände einer Mikrostruktur, insbesondere einer Wellenleiterstruktur, bilden, Abscheiden mindestens einer Maskierungsschicht auf die strukturierte Oberfläche, zumindest teilweises Entfernen der Maskierungsschicht vom Boden der Gräben, Vertiefen der Gräben durch zusätzliches Abtragen von Material des Diamant-Kristalls zumindest entlang der Seitenwände, sowie Bilden der freistehenden Mikrostruktur, insbesondere der freistehenden Wellenleiterstruktur, durch Unterätzen der Mikrostruktur, insbesondere der Wellenleiterstruktur.

Bei dem erfindungsgemäßen Verfahren wird zunächst die Oberfläche des Diamant-Kristalls strukturiert, um die Seitenwände und die Oberseite der späteren freistehenden Mikrostruktur, insbesondere der freistehenden Wellenleiterstruktur, zu bilden. Auf die strukturierte Oberfläche wird nachfolgend flächig mindestens eine Maskierungsschicht abgetragen. Die Maskierungsschicht wird in einem nachfolgenden Schritt selektiv nur im Bereich des Bodens der Gräben entfernt, um die Gräben in einem nachfolgenden Schritt zumindest entlang der Seitenwände vertiefen zu können.

Das zumindest teilweise Entfernen der Maskierungsschicht vom Boden der Gräben kann durch Abtragen von Material mittels Laserablation erfolgen. Alternativ zur selektiven Entfernung der Maskierungsschicht im Bereich der Böden der Gräben durch Laserablation kann auch ein so genannter Lift-Off Prozess zum Einsatz kommen, bei der ein Photolack bzw. Photoresist lithografisch so strukturiert wird, dass dieser nur im Bereich der Böden der Gräben verbleibt. Nach ganzflächiger Abscheidung der Maskierungsschicht wird der verbliebene Photoresist z. B. durch einen Lösemittelangriff entfernt, wodurch gleichzeitig auch die auf dem verbliebenen Photoresist vorhandene Maskierungsschicht abgelöst bzw. entfernt wird.

Durch das Vertiefen wird an einer jeweiligen Seitenwand ein Abschnitt gebildet, der nicht von der Maskierungsschicht bedeckt ist. Dieser Abschnitt der Seitenwand des Grabens ist einem Ätzangriff zugänglich und ermöglicht es, die Mikrostruktur, insbesondere die Wellenleiterstruktur, zu unterätzen. Der Ätzangriff erfolgt daher unterhalb der herzustellenden freistehenden Mikrostruktur bzw. Wellenleiterstruktur. Das Unterätzen erfolgt typischerweise mittels Hilfe eines isotropen Ätzprozesses in Form eines Trocken-Ätzprozesses.

Das Abtragen des Materials, das zumindest teilweise Entfernen der Maskierungsschicht und das zusätzliche Abtragen des Materials erfolgen im Gegensatz zum Ätzen mit Hilfe von anisotropen Verfahren, typischerweise durch Laserablation (s.u.). Sollte die verwendete Maskierungsschicht im verwendeten Wellenlängenbereich optisch absorbierend sein, sollte die Maskierungsschicht nach dem Freistellen der Mikrostrukturen vollständig von der strukturierten Oberfläche entfernt werden. Das Entfernen der Maskierungsschicht kann ebenfalls durch Laserablation erfolgen oder ggf. mit Hilfe eines Nass- oder eines Trockenätzprozesses.

Die Erfinder haben erkannt, dass sich herkömmliche Verfahren zur dreidimensionalen Strukturierung von Kristallen, bei denen freistehende Mikrostrukturen durch Unterätzen gebildet werden, bei einem Diamant-Kristall nicht anwenden lassen: Eine dreidimensionale Strukturierung der Oberfläche eines Diamant-Kristalls durch 3D-Lithographie und ein sich anschließendes reaktives Ionenätzverfahren ist aufgrund der geringen Selektivität (ca. 30 : 1) von bekannten Hartmasken, die beim Ätzen von Diamant mittels reaktivem Ionenätzen verwendet werden, nicht möglich. Mit einem derartigen Verfahren können lediglich dreidimensionale Tiefenstrukturen in der Größenordnung von wenigen 100 nm realisiert werden, die sich nicht als optisch nutzbare Mikrostrukturen bzw. Wellenleiterstrukturen eignen. Im Gegensatz dazu können bei dem hier beschriebenen Verfahren freistehende Mikrostrukturen erzeugt werden, die eine Höhe in der Größenordnung von Mikrometern aufweisen.

Bei einer Variante erfolgt das Unterätzen der Mikrostruktur, insbesondere der Wellenleiterstruktur, durch thermische Oxidation des Diamant-Kristalls bei einer Temperatur zwischen 600°C und 1100°C, z.B. zwischen 650°C und 1000°C, bevorzugt in einer Sauerstoff enthaltenden Atmosphäre, insbesondere in einem Sauerstoff-Plasma. Die thermische Oxidation des Diamant-Kristalls stellt einen isotropen Ätzprozess dar, bei dem nur die nicht von der Maskierungsschicht bedeckten Bereiche der Oberfläche des Diamant-Kristalls angegriffen werden. Die Prozessdauer der thermischen Oxidation richtet sich nach der Ätzgeschwindigkeit, die bei den jeweils eingestellten Prozessparametern (Temperatur, Druck, Sauerstoffgehalt in der Umgebung, etc.) vorherrscht und kann von wenigen Sekunden bis zu mehreren Minuten betragen. Der Sauerstoff enthaltenden Atmosphäre in der Umgebung des Diamant-Kristalls kann molekularer Sauerstoff beigemischt werden, es ist aber auch möglich, dass reaktiven Gase, die Sauerstoff enthalten, beispielsweise NO oder N₂O, der Sauerstoff enthaltenden Atmosphäre beigemischt werden. Es ist möglich, dass für das Unterätzen ein Sauerstoff-Plasma eingesetzt wird, z.B. wenn der Schritt des Unterätzens in einem herkömmlichen CVD-Reaktor durchgeführt wird. Durch das Sauerstoff-Plasma wird die Reaktivität des Sauerstoffs erhöht und die für die thermische Oxidation benötigte Prozess-Temperatur kann herabgesetzt werden.

Bei einer weiteren Variante wird zum Glätten der strukturierten Oberfläche eine thermische Oxidation der strukturierten Oberfläche (vor dem Abscheiden der Maskierungsschicht) bei einer Temperatur zwischen 600°C und 1100°C, z.B. zwischen 650°C und 1000°C oder zwischen 800°C und 1000°C, bevorzugt in einer Sauerstoff enthaltenden Atmosphäre durchgeführt. Bei dieser Variante erfolgt eine Glättung der strukturierten Oberfläche und somit auch der Mikrostrukturen bzw. der Wellenleiterstrukturen durch eine in der Regel kurze thermische Oxidation der strukturierten Oberfläche mit Zeitdauern, die üblicherweise zwischen wenigen Sekunden und einer Minute liegen. Die Prozessparameter, insbesondere die Temperatur, der Druck und die Zeitdauer der thermischen Oxidation werden gezielt eingestellt, um Rauigkeiten zu minimieren, ohne dass es hierbei zu einem Materialabtrag kommt, wie dies beim weiter oben beschriebenen Unterätzen der Fall ist. Grundlage für die Glättung ist die Tatsache, dass eine raue Oberfläche mehr Angriffsmöglichkeiten für eine oxidative Reaktion bietet als eine glatte Oberfläche und dass daher eine raue Oberfläche schneller oxidiert als eine glatte Oberfläche. Es versteht sich, dass eine solche Glättung von Mikrostrukturen bzw. von Wellenleiterstrukturen auch vorteilhaft angewandt werden kann, wenn keine freistehenden Mikrostrukturen bzw. Wellenleiterstrukturen gebildet werden, d.h. wenn die weiter oben beschriebenen Schritte wie das Abscheiden der mindestens einen Maskierungsschicht, etc. nicht durchgeführt werden.

Bei einer Variante erfolgt das Abscheiden der mindestens einen Maskierungsschicht durch chemisches Gasphasenabscheiden ("chemical vapour deposition", CVD) oder durch Atomlagenabscheiden ("Atomic layer deposition", ALD). Die Maskierungsschicht dient zum Schutz der strukturierten Oberfläche vor dem nachfolgenden isotropen Ätzangriff. Die Abscheidung der Maskierungsschicht durch einen CVD- oder einen ALD-Prozess ermöglicht eine konformale Abscheidung, bei der sowohl die Oberseite der Mikrostrukturen als auch deren Seitenwände möglichst homogen bedeckt werden, um eine isotrope Unterätzung nur an den gewünschten Stellen zu erzeugen. Als Materialien für die Maskierungsschicht haben sich temperaturstabile Nitride oder Oxide, beispielsweise SiO₂, Al₂O₃, SiN, oder andere amorphe, temperaturstabile Oxide oder Nitride wie TiO bzw. TiO₂, ZrO, TiN, AIN, ... als günstig erwiesen. Typische Schichtdicken der Maskierungsschicht liegen in der Größenordnung zwischen ca. 10 nm und ca. 1000 nm, idealerweise zwischen 200 nm und 300 nm.

Bei einer weiteren Variante erfolgt das Abtragen des Materials, das zumindest teilweise Entfernen der Maskierungsschicht und/oder das zusätzliche Abtragen des Materials durch Laserablation mittels eines bevorzugt gepulsten Laserstrahls. Für die Laserablation von Diamant-Material hat sich ein gepulster Laserstrahl in Form eines Ultrakurzpuls-Laserstrahls als günstig erwiesen (s.u.). Für das zumindest teilweise Entfernen der Maskierungsschicht kann ebenfalls ein Ultrakurzpuls-Laserstrahl eingesetzt werden, es ist aber auch möglich, dass das Entfernen der Maskierungsschicht im c/w-Betrieb oder mit einem Laserstrahl mit deutlich längeren Pulsdauern durchgeführt wird. Es ist möglich, dass für das teilweise Entfernen der Maskierungsschicht ein Laserstrahl verwendet wird, dessen Wellenlänge nicht mit der Wellenlänge des Laserstrahls übereinstimmt, der für das Abtragen bzw. für das zusätzliche Abtragen des Materials des Diamant-Kristalls verwendet wird.

Bei einer Weiterbildung dieser Variante liegt eine Temperatur des Diamant-Kristalls beim Abtragen des Materials und/oder beim zusätzlichen Abtragen des Materials bei mehr als 600°C, bevorzugt bei mehr als 700°C, insbesondere bei mehr als 800°C und bei weniger als 1000°C.

Die Erfinder haben erkannt, dass Diamant bis zu einer bestimmten Schwellentemperatur sehr inert ist und auch in Anwesenheit von Sauerstoff keinerlei reaktives Verhalten zeigt. Beim Überschreiten der Schwellentemperatur reagiert Diamant sehr schnell mit Sauerstoff und verbrennt hierbei (thermische Oxidation). Die Ablationsschwelle des Diamant-Materials nimmt mit zunehmender Temperatur ab und entsprechend nimmt - bei ansonsten gleichen Prozessbedingungen - die Ätzrate des Diamant-Materials zu. Wird die Schwellentemperatur überschritten, brennt das Diamant-Material in der Regel unkontrolliert ab, so dass die Temperatur des Diamant-Materials unterhalb der Schwellentemperatur gehalten werden sollte.

Es hat sich gezeigt, dass bei Temperaturen des Diamant-Materials von über 600°C, 700°C oder 800°C die Ablationsschwelle signifikant gesenkt und somit die Abtragsrate pro Laserpuls signifikant erhöht werden kann. Es ist daher günstig, die Temperatur des Diamant-Materials bei der Bildung der Mikrostruktur(en) knapp unterhalb der Schwellentemperatur des Diamant-Materials für die thermische Oxidation zu halten, die typischerweise in der Größenordnung von ca. 1000°C liegt.

Der Materialabtrag bei der Strukturierung des Diamant-Kristalls erfolgt daher bevorzugt durch eine Kombination aus einem Lasereintrag und einem Temperatureintrag. Durch die zusätzliche Temperatureinwirkung auf den Diamant-Kristall können die Pulsenergien des gepulsten Laserstrahls, der für die Laserablation verwendet wird, reduziert werden. Auf diese Weise kann die Strukturtreue und die Oberflächenqualität bei der Bildung der Mikrostrukturen verbessert werden. Der Temperatureintrag hat zudem den Vorteil, dass der Debris, der bei der Laserablation erzeugt wird, verringert wird, da amorphisierte Kohlenstoffanteile im Debris bei Temperaturen von mehr als 600°C aufgrund der im Vergleich zu Diamant geringeren Oxidationstemperatur sofort verbrennen.

Zum Aufheizen des Diamant-Kristalls auf die weiter oben angegebenen Temperaturen kann eine Temperier-Einrichtung verwendet werden. Bei der Temperier-Einrichtung handelt es sich in der Regel um eine Heizeinrichtung, ggf. kann es sich aber um eine Einrichtung handeln, die ausgebildet ist, das Diamant-Material sowohl zu heizen als auch zu kühlen. Bei der Temperier-Einrichtung kann es sich beispielsweise um eine Widerstandsheizung oder um einen über IR-Strahlung oder auf andere Weise geheizten Suszeptor, z.B. aus Silizium, handeln. Die Temperier-Einrichtung dient typischerweise dazu, nicht nur die Oberfläche des Diamant-Kristalls, die mit dem gepulsten Laserstrahl bestrahlt wird, sondern den gesamten Diamant-Kristall möglichst homogen aufzuheizen. Die Temperier-Einrichtung hält den Diamant-Kristall während der Ausbildung der Mikrostruktur(en) auf einer Temperatur, die in dem oben angegebenen Wertebereich liegt. Es ist möglich, aber nicht zwingend notwendig, mit Hilfe der Temperier-Einrichtung die Temperatur des Diamant-Kristalls auf einen bestimmten Temperatur-Wert einzustellen und während des Ausbildens der Mikrostruktur(en) auf dieser Temperatur zu halten. Es ist möglich, die Temperatur an der Oberfläche des Diamant-Kristalls mit Hilfe eines Temperatursensors oder dergleichen zu überwachen und ggf. auf einen vorgegebenen Temperatur-Sollwert oder einen vorgegebenen Soll-Temperaturverlauf zu regeln.

Bei einer Weiterbildung umfasst das Abtragen des Materials: Einstrahlen des gepulsten Laserstrahls auf die Oberfläche des Diamant-Kristalls, Bewegen des gepulsten Laserstrahls und des Diamant-Kristalls relativ zueinander entlang einer Vorschubrichtung entlang mindestens einer Ablationsbahn, wobei bevorzugt zum Bilden der Gräben der Laserstrahl und der Diamant-Kristall relativ zueinander mehrfach entlang von lateral versetzten Ablationsbahnen bewegt werden.

Zur Bildung der Mikrostruktur bzw. eines jeweiligen Grabens werden in der Regel systematisch mehrere Ablationsbahnen parallel zueinander versetzt. Die Ablationsbahnen verlaufen entweder geradlinig oder bilden gekrümmte Strukturen in der XY-Ebene auf der Oberfläche des Kristalls. Auf diese Weise können z.B. Mäanderstrukturen oder Taper erzeugt werden. Typischerweise werden mehrere Ablationsbahnen lateral sowie ggf. vertikal, d.h. in Dickenrichtung des Diamant-Kristalls, überlagert. Auf diese Weise können in dem Diamant-Kristall Gräben mit einer vorgegebenen Breite und Tiefe erzeugt werden. Abhängig von der gewünschten Geometrie können auch die Laserparameter abhängig von der jeweiligen Ablationsbahn angepasst werden. Für Details der Ausbildung von Mikrostrukturen in Form von (Steg-)Wellenleitern zwischen zwei benachbarten Gräben sei auf die DE 10 2019 214 684 A1 verwiesen, die durch Bezugnahme in ihrer Gesamtheit zum Inhalt dieser Anmeldung gemacht wird.

Die beiden Gräben, zwischen denen die Mikrostruktur gebildet wird, weisen einen vorgegebenen Abstand voneinander auf, der die Breite der Mikrostruktur definiert. Es ist nicht erforderlich, dass dieser Abstand konstant ist, vielmehr ist es möglich, dass der Abstand und damit die Breite der Mikrostruktur bzw. des (Steg-)Wellenleiters in Längsrichtung der Gräben variiert. Gleiches gilt für die Tiefe der Gräben, welche die Höhe der Seitenwände der Mikrostruktur und damit die Höhe der Mikrostruktur festlegen.

Beim Einstrahlen des Laserstrahls auf die Oberfläche des Diamant-Kristalls kann eine Strahlachse des Laserstrahls senkrecht zur in der Regel planen Oberfläche des Diamant-Kristalls ausgerichtet sein. In diesem Fall erfolgt typischerweise eine Translationsbewegung einer Lagereinrichtung, beispielsweise in Form einer Translations-Plattform, auf welcher der in der Regel plattenförmige Kristall beim Bilden der Mikrostrukturen gelagert ist, in einer horizontalen Ebene (parallel zur Oberfläche des Diamant-Kristalls). Der Laserbearbeitungskopf, aus dem der gepulste Laserstrahl austritt und auf die Oberfläche des Diamant-Kristalls ausgerichtet wird, kann hierbei ortsfest angeordnet sein, es ist aber auch möglich, dass der Laserbearbeitungskopf über die Oberfläche des Diamant-Kristalls bewegt wird. Der aus dem Laserbearbeitungskopf austretende Laserstrahl wird in diesem Fall typischerweise auf die Oberfläche des Diamant-Kristalls fokussiert.

Beim Bewegen des Laserstrahls und des Diamant-Kristalls relativ zueinander kann alternativ eine Strahlachse des Laserstrahls unter einem Winkel gegenüber einer Normalenrichtung der Oberfläche des Diamant-Kristalls verkippt werden, wobei der Winkel bevorzugt in einer Ebene senkrecht zur Vorschubrichtung liegt. In diesem Fall trifft der Laserstrahl nicht senkrecht, sondern unter einem von 0° verschiedenen Winkel auf die Oberfläche des Diamant-Kristalls. Die Vorschubrichtung der Ablationsbahn, entlang derer das Material abgetragen wird, verläuft in der Regel parallel zur Bearbeitungsebene bzw. zur Oberfläche des Diamant-Kristalls. Der Winkel, unter dem der Laserstrahl zur Normalenrichtung der Oberfläche verkippt wird, liegt typischerweise in einer Ebene, die senkrecht zur (ggf. ortsabhängig variierenden) Vorschubrichtung verläuft, dies ist aber nicht zwingend erforderlich.

Wie dies in der DE 10 2019 214 684 A1 beschrieben ist, die durch Bezugnahme in ihrer Gesamtheit zum Inhalt dieser Anmeldung gemacht wird, kann durch die Ausrichtung unter dem Winkel erreicht werden, dass eine der beiden Seitenwände bzw. Seitenkanten der Ablationsbahn steiler und die andere Seitenwand der Ablationsbahn, die in dem Diamant-Kristall erzeugt wird, flacher verläuft als dies beim senkrechen Einfall des Laserstrahls auf die Oberfläche der Fall wäre.

Der oben beschriebene Winkel liegt typischerweise zwischen 2° und 60°, bevorzugt zwischen 10° und 45°, insbesondere zwischen 15° und 30°. Es hat sich als günstig erwiesen, den Winkel, unter dem der Laserstrahl zur Normalenrichtung ausgerichtet ist, in dem angegebenen Intervall zu wählen, um zu erreichen, dass eine der beiden Seitenwände der Ablationsbahn möglichst steil, d.h. möglichst parallel zur Normalenrichtung der Oberfläche, ausgerichtet ist. Für den Fall, dass die Seitenwand der Ablationsbahn bzw. des Grabens in dem Diamant-Kristall die Seitenwand einer Mikrostruktur, beispielsweise eines Wellenleiters, bildet, ist eine möglichst steile Ausrichtung günstig, da auf diese Weise Lichtverluste durch den Austritt von in dem Wellenleiter geführtem Licht durch die Seitenwand hindurch gering gehalten werden können. Durch steile Seitenwände und ein einstellbares Aspektverhältnis von Höhe zu Breite können in dem Wellenleiter rotationssymmetrische Eigenmoden geführt werden.

Für den Fall, dass geradlinige Ablationsbahnen erzeugt werden sollen, ist die Vorschubrichtung bei der Relativbewegung des Laserstrahls und des Diamant-Kristalls konstant. Die Vorschubrichtung kann ortsabhängig variieren, wenn krummlinige Ablationsbahnen bzw. Mikrostrukturen erzeugt werden sollen. In beiden Fällen sollte sichergestellt sein, dass der Winkel, unter dem der Laserstrahl gegenüber der Normalenrichtung der Oberfläche des Diamant-Kristalls verkippt wird, unabhängig von der gewählten - ggf. ortsabhängig variierenden - Vorschubrichtung eingestellt werden kann. Bei einem herkömmlichen, ortsfesten Laser-Scanner zur Bearbeitung eines ortsfest angeordneten Werkstücks ist dies typischerweise nicht der Fall, da der Laserstrahl an einer jeweiligen Position an der Oberfläche des Werkstücks unter einem vorgegebenen Scanwinkel ausgerichtet ist. Zur Verkippung der Strahlachse des Laserstrahls unter einem Winkel zur Normalenrichtung der Oberfläche des Diamant-Kristalls unabhängig von der Vorschubrichtung bestehen verschiedene Möglichkeiten. Für Details sei auf die DE 10 2019 214 684 A1 verwiesen.

Wird ein Laserstrahl mit einem runden Strahlprofil unter einem Winkel zur Oberfläche des Diamant-Kristalls eingestrahlt, so trifft dieser mit einem elliptischen, nicht rotationssymmetrischen Strahlprofil (Spot) auf die Oberfläche. Um dennoch ein rundes Strahlprofil an der Oberfläche zu erzeugen, kann ein Laserstrahl mit einem elliptischen Strahlprofil auf die Oberfläche eingestrahlt werden. Ein solches elliptisches Strahlprofil kann mittels einer strahlformenden Optik, beispielsweise mit Hilfe einer Zylinderlinse bzw. eines Linsenteleskops oder dergleichen, erzeugt werden. Insbesondere kann eine solche strahlformende Optik ausgebildet sein, das Aspekt-Verhältnis des elliptischen Strahlprofils zu verändern. Für Details der Einstrahlung eines Laserstrahls mit einem elliptischen Strahlprofil auf einen Kristall sei ebenfalls auf die weiter oben zitierte DE 10 2019 214 684 A1 verwiesen.

Es kann ggf. günstig sein, wenn das Strahlprofil des Laserstrahls gezielt von einer runden bzw. rotationssymmetrischen Geometrie abweicht, beispielsweise um einen Linienfokus an der Oberfläche des Diamant-Kristalls zu erzeugen, wie dies z.B. in der WO 2018/019374 A1 beschrieben ist, die durch Bezugnahme in ihrer Gesamtheit zum Inhalt dieser Anmeldung gemacht wird. Ein solcher Linienfokus kann beispielsweise durch die Verwendung von asymmetrischen Moden erzeugt werden. Bei der Verwendung eines Linienfokus kann ebenfalls die Rauigkeit der hergestellten Mikrostrukturen verbessert werden.

Bei einer weiteren Weiterbildung wird der gepulste Laserstrahl mit einer Wellenlänge von weniger als 450 nm auf die Oberfläche des Diamant-Kristalls eingestrahlt. Es hat sich gezeigt, dass die Verwendung einer Wellenlänge des gepulsten Laserstrahls im UV-Wellenlängenbereich die Qualität der bei der Laserablation hergestellten (optisch nutzbaren) Mikrostrukturen in dem Diamant-Material deutlich verbessert. Für das Entfernen der Markierungsschicht kann ggf. ein Laserstrahl mit einer größeren Wellenlänge verwendet werden.

Der gepulste Laserstrahl wird typischerweise mit Pulsdauern von weniger als 20 ps, bevorzugt von weniger als 850 fs, besonders bevorzugt von weniger als 500 fs, insbesondere von weniger als 300 fs auf die Oberfläche des Diamant-Kristalls eingestrahlt, um das Material des Diamant-Kristalls abzutragen. Es hat sich gezeigt, dass die Verwendung von Pulsdauern im fs-Bereich die Qualität der hergestellten Mikrostrukturen erheblich verbessert. Wie weiter oben beschrieben wurde, ist es für das Entfernen der Maskierungsschicht nicht zwingend erforderlich, dass der Laserstrahl die weiter oben beschriebenen Pulsdauern aufweist.

Der gepulste Laserstrahl kann beispielsweise von einem Festkörperlaser oder von einem Excimerlaser erzeugt werden. Festkörperlaser ermöglichen die Erzeugung von Laserpulsen mit geringen Pulsdauern im fs-Bereich. Durch Frequenzverdopplung bzw. Frequenz-Vervielfachung können Festkörperlaser Wellenlängen im UV-Wellenlängenbereich, z.B. bei 343 nm, erzeugen. Alternativ ist es möglich, dass der gepulste Laserstrahl von einem Excimer-Laser erzeugt wird.

Als Laserparameter werden für die weiter oben beschriebene Ablation typischerweise Repetitionsraten zwischen ca. 600 kHz und 1000 kHz verwendet. Es ist möglich, dass die Repetitionsrate variiert, d.h. dass kurze, hohe Repetitionsraten gefolgt von langen Pulspausen für die Ablation verwendet werden (Burst-Betrieb). Typische Vorschubgeschwindigkeiten liegen zwischen ca. 500 und 1500 mm/s und sind damit höher als bei herkömmlichen Herstellungsverfahren. Die durchschnittliche Laserleistung liegt in der Größenordnung zwischen ca. 1 und 2,5 Watt, der Energieeintrag pro Laserpuls liegt in der Größenordnung zwischen ca. 1,5 und 5 µJ. Grundsätzlich lassen sich durch eine gezielte Kombination von Pulsenergie, Pulsdauer und Pulsanzahl sowie Vorschubgeschwindigkeit und Winkel des Laserstrahls relativ zur Oberfläche gezielt die Abtragsrate und die Strukturtiefe einstellen.

Bei einer weiteren Variante wird der Diamant-Kristall beim Unterätzen, beim Abtragen von Material, beim zusätzlichen Abtragen von Material und/oder beim Glätten der strukturierten Oberfläche bevorzugt gemeinsam mit der Temperier-Einrichtung in einer gasdichten Prozesskammer angeordnet. Die gasdichte Prozesskammer kann mit einer definierten Gas-Atmosphäre beaufschlagt werden, was die Prozesskontrolle vereinfacht. Insbesondere für den Fall, dass die Temperier-Einrichtung den Diamant-Kristall durch die Abgabe von Kontaktwärme (Konduktion) aufheizt, ist es günstig bzw. erforderlich, dass die Temperier-Einrichtung gemeinsam mit dem Diamant-Kristall in der Prozesskammer angeordnet ist. Zur Einstrahlung des gepulsten Laserstrahls in die Prozesskammer bei der Laserablation weist die Prozesskammer typischerweise ein Fenster auf, das für die Wellenlänge des gepulsten Laserstrahls transparent ist, z.B. ein Fenster aus Quarzglas. Die Prozesskammer kann mit einer Pumpe in Verbindung stehen, welche Gas aus dem Innenraum der Prozesskammer absaugt. Bei der Pumpe kann es sich insbesondere um eine Vakuum-Pumpe handeln. Mit Hilfe der Prozesskammer können typischerweise alle relevanten Prozessparameter wie die Temperatur des Diamant-Kristalls bzw. der Umgebung des Diamant-Kristalls, der Druck und der Sauerstoffgehalt eingestellt werden, wie weiter unten beschrieben wird.

In einem Innenraum der Prozesskammer kann die weiter oben beschriebene Sauerstoff enthaltende Atmosphäre erzeugt werden, die beim Unterätzen, beim Glätten der strukturierten Oberfläche, beim Abtragen und/oder beim zusätzlichen Abtragen von Material des Diamant-Kristalls verwendet werden kann, um die thermische Oxidation bzw. die Einwirkung des gepulsten Laserstrahls auf das Diamant-Material zu verstärken. Die Verwendung von Sauerstoff als reaktivem Gasbestandteil in der Prozesskammer hat sich für die Durchführung des Verfahrens als günstig erwiesen. Wie weiter oben beschrieben wurde, ist auch der Einsatz von anderen reaktiven Gasen möglich, beispielsweise von NO oder N₂O. Der SauerstoffGehalt bzw. der Partialdruck des Sauerstoffs in der Prozesskammer kann bevorzugt mit Hilfe eines geeigneten Einlasses eingestellt werden, beispielsweise mit Hilfe eines steuerbaren Ventils.

In der Prozesskammer kann auch mindestens Inertgas, bevorzugt Stickstoff, enthalten sein. Das Inertgas ermöglicht es, den Laserablationsprozess kontrolliert ablaufen zu lassen, insbesondere wenn ein reaktiver Gasbestandteil in der Prozesskammer enthalten ist. Bevorzugt kann der Gehalt bzw. der Partialdruck des Inertgases in der Prozesskammer eingestellt werden, beispielsweise indem das Inertgas der Prozesskammer mit Hilfe eines steuerbaren Einlasses, z.B. unter Verwendung eines schalt- bzw. steuerbaren Ventils zugeführt wird. Es ist günstig, wenn ein praktisch beliebiges Mischungsverhältnis des reaktiven Gases und des Inertgases in der Prozesskammer eingestellt werden kann. Um dies zu erreichen, können das Inertgas und das reaktive Gas der Prozesskammer bevorzugt über zwei getrennt einstellbare bzw. steuerbare Ventile zugeführt werden.

Insbesondere für den Schritt des Unterätzens sowie für den Schritt des Glättens ist es günstig, wenn ein Gasdruck in der Prozesskammer eingestellt, bevorzugt geregelt wird, um die Prozesskontrolle zu verbessern. Wie weiter oben beschrieben wurde, steht die Prozesskammer typischerweise mit einer Pumpe in Verbindung, welche Gas aus dem Innenraum der Prozesskammer absaugt. Mit Hilfe eines Druckmessgeräts kann der Gesamtdruck bzw. der Gasdruck in der Prozesskammer gemessen werden und mit Hilfe einer Steuer- bzw. Regeleinrichtung kann die Pumpe oder ein Ventil geeignet angesteuert werden, um den Gesamtdruck in der Prozesskammer auf einem vorgegebenen Soll-Wert zu halten. Die Reduktion des Gasdrucks in der Prozesskammer dient zum Herabsetzen der Reaktionsgeschwindigkeit während der Kristallbearbeitung und bietet einen weiteren Freiheitsgrad in der Prozesskontrolle. Der Gasdruck in der Prozesskammer liegt bei druckreduzierter Bearbeitung typischerweise in einem Bereich zwischen 10 mbar und 100 mbar. Für den Fall, dass die Pumpe über ein schaltbares Ventil mit dem Innenraum der Prozesskammer verbunden ist, kann die Pumpe durch das Schließen des Ventils vom Innenraum der Prozesskammer getrennt werden, sobald der gewünschte Gesamtdruck in der Prozesskammer erreicht ist.

Bei einer weiteren Weiterbildung ist der Diamant-Kristall im Bereich der freistehenden Mikrostruktur, insbesondere der freistehenden Wellenleiterstruktur, mit Farbzentren, bevorzugt mit NV-Zentren, dotiert. Bei der hier beschriebenen dreidimensionalen Strukturierung des Diamant-Kristalls können gezielt freistehende Mikrostrukturen erzeugt werden, in deren Volumen der Diamant-Kristall mit Farbzentren dotiert ist. Es ist möglich, die Dotierung mit den Farbzentren auf die freistehenden Mikrostrukturen, insbesondere die freistehenden Wellenleiterstrukturen, zu begrenzen, d.h. dass der Diamant-Kristall außerhalb der freistehenden Wellenleiterstrukturen nicht mit Farbzentren dotiert ist. Freistehende Wellenleiterstrukturen, die mit Farbzentren, insbesondere mit NV-Zentren, dotiert sind, können beispielsweise als aktive Sensor- bzw. Messbereiche verwendet werden, um eine lokalisierte Messung z.B. von Magnetfeldern oder von Verspannungen zu ermöglichen. Die freistehende Wellenleiterstruktur ermöglicht es, durch eine geeignete Wahl der Geometrie die Anregungsdichte von Anregungslicht zu optimieren, das der freistehenden Wellenleiterstruktur zugeführt wird. Durch die Freistellung kann die Ausdehnung der Messbereiche in vertikaler Richtung begrenzt werden. Für die Optimierung der Anregungsdichte kann zudem die Geometrie der freistehenden Wellenleiterstruktur angepasst werden, beispielsweise kann der Querschnitt der freistehenden Wellenleiterstruktur in Propagationsrichtung des Anregungslichts abnehmen, was durch eine sich verjüngende, kegelstumpfartige bzw. keilförmige Geometrie erreicht werden kann.

Bei einer Weiterbildung umfasst das Verfahren: Bilden mindestens einer weiteren Mikrostruktur, bevorzugt mindestens einer weiteren Wellenleiterstruktur, in dem Diamant-Kristall, die insbesondere zur Zuführung von Anregungslicht zu der freistehenden Wellenleiterstruktur und/oder zur Abführung von Fluoreszenzlicht von der freistehenden Wellenleiterstruktur dient, wobei der Diamant-Kristall im Bereich der mindestens einen weiteren Mikrostruktur, bevorzugt der mindestens einen weiteren Wellenleiterstruktur, nicht mit Farbzentren, bevorzugt nicht mit NV-Zentren, dotiert ist. Wie weiter oben beschrieben wurde, kann die freistehende Wellenleiterstruktur als aktiver Bereich, z.B. als Messbereich, dienen, in dem Anregungslicht in Fluoreszenzlicht konvertiert wird. Die weiteren Wellenleiterstrukturen können als passive Bereiche zur Verbesserung der Lichtführung bei der Zuführung von Anregungslicht zu der freistehenden Wellenleiterstruktur und zur Abführung von Fluoreszenzlicht von der freistehenden Wellenleiterstruktur bzw. zum Sammeln der Lichtemissionen der Farbzentren dienen.

Um eine mechanische Stabilität der freigestellten Mikrostrukturen bzw. Wellenleiterstrukturen sicher zu stellen bzw. eine mechanisch stabile Verbindung der Mikrostrukturen bzw. der Wellenleiterstruktur mit dem verbliebenen Diamantsubstrat zu gewährleisten und um die freistehenden Mikrostrukturen bzw. Wellenleiterstrukturen an das umzusetzende photonische Layout anzupassen können Stützstrukturen verwendet werden. Die Stützstrukturen sollten möglichst wenig Berührungsfläche mit den eigentlichen Wellenleiterstrukturen haben, jedoch so groß strukturiert sein, dass sie bei der Freistellung der Mikrostrukturen bzw. der Wellenleiter nicht vollständig unterätzt werden. Die weiteren Mikrostrukturen bzw. die weiteren Wellenleiterstrukturen werden typischerweise in den Diamant-Kristall eingeschrieben, bevor die Maskierungsschicht auf die strukturierte Oberfläche abgeschieden wird.

Bei einer Weiterbildung umfasst der der Diamant-Kristall eine erste Schicht, die mit den Farbzentren, bevorzugt mit den NV-Zentren, dotiert ist, und der Diamant-Kristall umfasst eine zweite Schicht, die an die erste Schicht angrenzt und die nicht mit den Farbzentren, bevorzugt nicht mit den NV-Zentren, dotiert ist, wobei in der ersten Schicht die freistehenden Mikrostrukturen, bevorzugt die freistehenden Wellenleiterstrukturen, gebildet werden, und wobei in der zweiten Schicht, die bevorzugt an die Oberfläche des Diamant-Kristalls angrenzt, die weiteren Mikrostrukturen, bevorzugt die weiteren Wellenleiterstrukturen, gebildet werden. Bei dieser Weiterbildung kann das Licht, z.B. in Form von Anregungslicht, ausgehend von einer Einkoppelposition mit Hilfe der weiteren Wellenleiterstrukturen zunächst in der zweiten, undotierten Schicht geführt werden. Das Licht kann dann an einem Übergang zwischen der weiteren Wellenleiterstruktur und der freistehenden Wellenleiterstruktur in die erste Schicht überführt werden, die mit den Farbzentren dotiert ist und die z.B. zur sensorischen Messung dienen kann. Dies hat den Vorteil, dass das Licht ungestört bis zu einem jeweiligen Messbereich innerhalb des Diamant-Materials geführt werden kann und nur an dem Ort mit den Farbzentren interagiert, an dem eine Messung erfolgen soll.

Zur Herstellung eines derartig strukturierten Diamant-Kristalls wird als Ausgangsmaterial typischerweise ein Diamant-Kristall verwendet, bei dem die erste Schicht eine vergrabene Schicht bildet, die mit den Farbzentren dotiert ist, während die zweite Schicht an die Oberfläche des Diamant-Kristalls angrenzt, von der das Material des Diamant-Kristalls abgetragen wird. Die dotierte vergrabene Schicht kann auf eine für den Fachmann bekannte Art und Weise in dem Diamant-Kristall erzeugt werden. In der zweiten, oberflächennahen Schicht werden die weiteren Wellenleiterstrukturen gebildet, während in der ersten, vergrabenen Schicht die freistehenden Mikrostrukturen bzw. Wellenleiterstrukturen gebildet werden. Die Bildung der freistehenden Wellenleiterstrukturen und der weiteren Wellenleiterstrukturen kann in diesem Fall erfolgen, indem Gräben gebildet werden, deren Tiefe variiert, so dass die Gräben sich zumindest entlang eines Abschnitts, entlang dessen die freistehenden Mikrostrukturen gebildet werden, in die erste, vergrabene Schicht erstrecken, um die Seitenwände der freistehenden Mikrostrukturen zu bilden, während sich die Gräben entlang eines Abschnitts, entlang dessen die weiteren Mikro- bzw. Wellenleiterstrukturen gebildet werden - mit Ausnahme eines Übergangsbereichs - nicht in die erste Schicht erstreckt. Grundsätzlich ist es aber auch möglich, dass die Rolle der ersten Schicht und der zweiten Schicht vertauscht ist, d.h. dass die erste Schicht, welche die Farbzentren aufweist, an die Oberfläche des Diamant-Kristalls angrenzt. Der Diamant-Kristall kann beispielsweise über chemische Gasphasenabscheidung (CVD) hergestellt werden. Um die Dotierung in der ersten Schicht, nicht aber in der zweiten Schicht zu erzielen, kann beispielsweise Dotiergas während des CVD-Wachstumsprozesses gezielt zu- und abgeschaltet werden.

Bei einer Weiterbildung umfasst das Strukturieren der Oberfläche das Abtragen des Materials der zweiten Schicht oberhalb der zu bildenden Mikrostruktur, insbesondere der zu bildenden Wellenleiterstruktur, zum Freilegen der Oberseite der zu bildenden Mikrostruktur, insbesondere der zu bildenden Wellenleiterstruktur. Für den Fall, dass die freistehende Mikro- bzw. Wellenleiterstruktur in der zweiten, vergrabenen Schicht gebildet wird, ist es erforderlich, dass das Material der ersten Schicht oberhalb der zu bildenden Mikro- bzw. Wellenleiterstruktur abgetragen wird, um die Oberseite der freistehenden Mikro- bzw. Wellenleiterstruktur zu erzeugen. In einem an die Oberseite der Mikrostruktur angrenzenden Bereich erfolgt typischerweise ebenfalls ein Materialabtrag in der zweiten Schicht, um einen Übergangsbereich zwischen der freistehenden Mikrostruktur und denjenigen weiteren Mikrostrukturen zu bilden, die sich an die freistehende Mikrostruktur anschließen. Die Freistellung der Mikrostruktur bzw. der Wellenleiterstruktur erfolgt wie weiter oben beschrieben, d.h. durch das Abtragen von Material zum Erzeugen der Gräben, das Abscheiden einer Maskierungsschicht, das teilweise Entfernen der Maskierungsschicht und das anschließende (isotrope) Unterätzen.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung einer Vorrichtung zur Bildung von Wellenleiterstrukturen an einem beheizten Diamant-Kristall durch Abtragen von Material zur Ausbildung von mehreren parallel verlaufenden Gräben mittels eines gepulsten Laserstrahls,
- Fig. 2: zwei der Gräben von Fig. 1 im Querschnitt bei deren Herstellung durch Laserablation,
- Fig. 3: eine schematische Darstellung einer Vorrichtung analog zu Fig. 1, bei welcher der mit einer Maskierungsschicht bedeckte Diamant-Kristall in einer gasdichten Prozesskammer angeordnet ist, um die Wellenleiterstrukturen durch eine isotrope Oxidation des Diamant-Kristalls freizustellen,
- Fig. 4a-c: Darstellungen einer thermischen Oxidation zur Glättung der Wellenleiterstrukturen, die bei dem in Zusammenhang mit Fig. 1 beschriebenen Materialabtrag gebildet wurden,
- Fig. 5a-g: Darstellungen von mehreren Verfahrensschritten zum Bilden der freistehenden Wellenleiterstrukturen von Fig. 3, sowie
- Fig. 6a-d: Darstellungen von mehreren Verfahrensschritten zum Bilden von freistehenden Wellenleiterstrukturen in einer mit NV-Zentren dotierten vergrabenen Schicht eines Diamant-Kristalls.

In der folgenden Beschreibung der Zeichnungen werden für gleiche bzw. funktionsgleiche Bauteile identische Bezugszeichen verwendet.

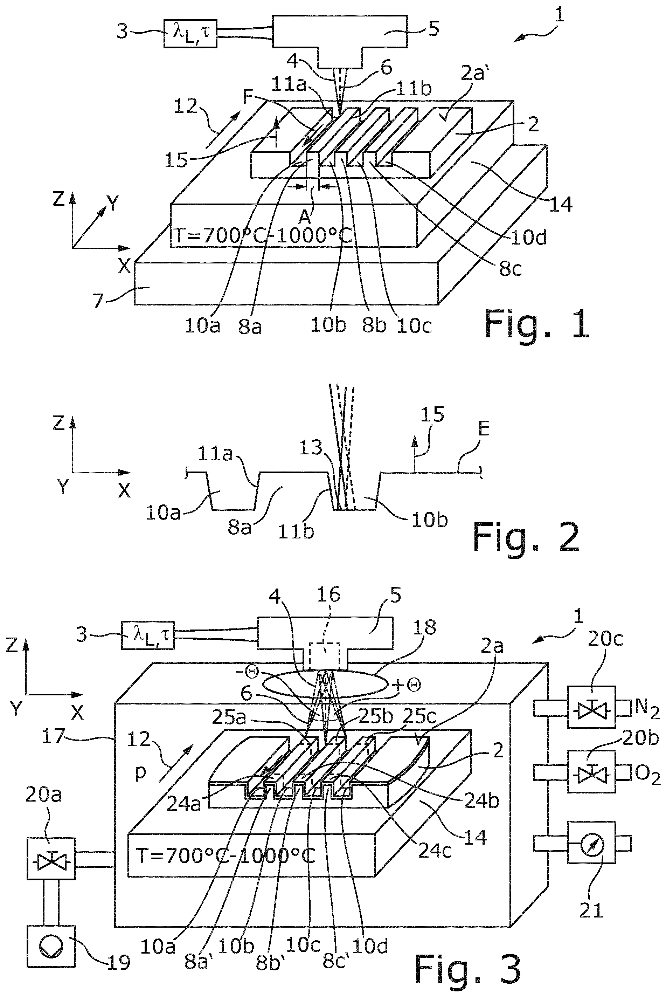

**Fig. 1** zeigt einen beispielhaften Aufbau einer Vorrichtung 1 zur Bildung von Mikro- bzw. von Wellenleiterstrukturen an einem Substrat in Form eines Diamant-Kristalls 2 (Diamant-Einkristall). Die Vorrichtung 1 umfasst eine Laserquelle 3 zur Erzeugung eines Laserstrahls 4, der über eine in Fig. 1 angedeutete Strahlführung einem Laserbearbeitungskopf 5 zugeführt wird. Der Laserbearbeitungskopf 5 richtet den Laserstrahl 4 auf den Diamant-Kristall 2 aus, genauer gesagt auf eine Oberfläche 2a' des Diamant-Kristalls 2, die im gezeigten Beispiel die Oberseite des Diamant-Kristalls 2 bildet. Bei der in Fig. 1 gezeigten Oberfläche handelt es sich um eine strukturierte Oberfläche 2a' des Diamant-Kristalls 2 nach der Bildung der Mikrostrukturen, die durch Materialabtrag aus einer planen Oberfläche des Diamant-Kristalls 2 gebildet wurde.

Bei der Laserquelle 3 handelt es sich bei dem in Fig. 1 gezeigten Beispiel um einen Festkörperlaser, der zur Erzeugung des Laserstrahls 4 bei einer Wellenlänge λ_{L} von 343 nm ausgebildet ist. Bei dem Festkörpermedium der Laserquelle 3 kann es sich beispielsweise um Yb:YAG handeln. Die Laserquelle 3 kann auch ausgebildet sein, einen Laserstrahl 4 bei einer anderen Wellenlänge im Wellenlängenbereich von weniger als 450 nm zu erzeugen.

Die Laserquelle 3 ist ausgebildet, einen gepulsten Laserstrahl 4 mit Pulsdauern im ps- bzw. fs-Bereich zu erzeugen. Für das nachfolgend beschriebene Verfahren haben sich Pulsdauern τ von weniger als 20 ps, beispielsweise von weniger als 850 fs, insbesondere von weniger als 500 fs, ggf. von weniger als 300 fs als vorteilhaft erweisen.

Bei der Laserquelle 3, die zur Erzeugung eines gepulsten Laserstrahls 4 mit derartigen Pulsdauern ausgebildet ist, kann es sich beispielsweise um einen Scheiben-, Slab- oder Faserlaser handeln. Alternativ kann ggf. ein Excimer-Laser verwendet werden, auch wenn dieser in der Regel nicht geeignet ist, um Pulsdauern im fs-Bereich zu erzeugen.

Der gepulste Laserstrahl 4 wird auf die dem Laserbearbeitungskopf 5 zugewandte Oberfläche 2a des Diamant-Kristalls 2 eingestrahlt. Wie in Fig. 1 zu erkennen ist, ist eine Strahlachse 6 des Laserstrahls 4 senkrecht zur Oberfläche 2a des Diamant-Kristalls 2 ausgerichtet, die im gezeigten Beispiel die Bearbeitungsebene bildet. Der Diamant-Kristall 2 ist auf einer Translations-Plattform 7 gelagert, die mit Hilfe von nicht bildlich dargestellten Aktuatoren in X-Richtung sowie unabhängig davon in Y-Richtung sowie in Z-Richtung eines XYZ-Koordinatensystems verschoben werden kann. Die Translations-Plattform 7 kann auch um eine in Z-Richtung ausgerichtete Drehachse gedreht werden.

Wie in Fig. 1 zu erkennen ist, werden bei der materialabtragenden Bearbeitung des Diamant-Kristalls 2 mittels des gepulsten Laserstrahls 4 Mikrostrukturen in Form von drei parallel ausgerichteten, in Y-Richtung verlaufenden Wellenleiterstrukturen in Form von Stegwellenleitern 8a-c gebildet, die einen im Wesentlichen rechteckigen Querschnitt aufweisen. Zu diesem Zweck werden mittels des gepulsten Laserstrahls 4 vier parallel ausgerichtete, sich ebenfalls in Y-Richtung erstreckende Gräben 10a-d in den Diamant-Kristall 2 eingebracht. Die drei Stegwellenleiter 8a-c sind jeweils zwischen zwei benachbarten Gräben 10a-d angeordnet.

Wie in Fig. 1 beispielhaft für den ersten Stegwellenleiter 8a dargestellt ist, weisen der erste Graben 10a und der benachbarte zweite Graben 10b einen vorgegebenen, konstanten Abstand A zueinander auf, der im gezeigten Beispiel am Boden der beiden Gräben 10a,b gemessen wird und der beispielsweise bei ca. 15 µm liegen kann. Eine rechte Seitenwand 11a des ersten Grabens 10a und eine benachbarte, dem ersten Graben 10a zugewandte linke Seitenwand 11b des zweiten Grabens 10b bilden die Seitenwände 11a, 11b des ersten Stegwellenleiters 8a. Entsprechendes gilt für die Gräben 10b-d und den zweiten und dritten Stegwellenleiter 8b, 8c.

Um die Gräben 10a-d zu erzeugen und auf diese Weise die Stegwellenleiter 8a-c zu bilden, werden der gepulste Laserstrahl 4 und der Diamant-Kristall 2 relativ zueinander bewegt. Der Laserbearbeitungskopf 5 ist bei dem in Fig. 1 gezeigten Beispiel ortsfest angeordnet. Zum Erzeugen einer Bewegung des gepulsten Laserstrahls 4 und des Diamant-Kristalls 2 relativ zueinander wird daher die Translations-Plattform 7 entlang einer Vorschubrichtung 12 bewegt, die der Y-Richtung des XYZ-Koordinatensystems entspricht. Der gepulste Laserstrahl 4 wird hierbei zur Erzeugung eines jeweiligen Grabens 10a-d mehrfach entlang von lateral (d.h. in X-Richtung) versetzten Ablationsbahnen 13 bewegt, wie dies beispielhaft in **Fig. 2** für den zweiten Graben 10b dargestellt ist. Es versteht sich, dass die Bewegung des Diamant-Kristalls 2 entlang einer jeweiligen Ablationsbahn 13 in positiver Y-Richtung erfolgen kann und die benachbarte Ablationsbahn 13 in negativer Y-Richtung abgefahren wird, um den Ablationsprozess zu beschleunigen.

Wie in Fig. 1 ebenfalls zu erkennen ist, ist der Diamant-Kristall 2 nicht unmittelbar auf der Translations-Plattform 7 angeordnet, sondern auf einer Temperier-Einrichtung 14 in Form eines heizbaren Suszeptors, der z.B. aus einem metallischen Material, aus einer Keramik oder aus Silizium gebildet sein kann. Der Suszeptor wird während der Ablation des Materials des Diamant-Kristalls 2 elektrisch über eine Widerstandsheizung auf eine Temperatur T aufgeheizt, die im gezeigten Beispiel zwischen 700°C und 1000°C liegt. Die Temperatur T des Diamant-Kristalls 2, insbesondere auch die Temperatur T an der Oberfläche 2a des Diamant-Kristalls 2, liegt ebenfalls in dem Temperaturbereich zwischen 700°C und 1000°C. Durch das Aufheizen des Diamant-Kristalls 2 wird die Ätzrate während des Materialabtrags erhöht. Die Ätzrate kann durch die Erhöhung der Temperatur T des Diamant-Kristalls 2 aber nicht beliebig gesteigert werden, da beim Überschreiten einer bestimmten Schwellentemperatur, die typischerweise bei ca. 1000°C liegt, das Diamant-Material sehr schnell mit Sauerstoff reagiert und verbrennt. Es ist daher erforderlich, den Diamant-Kristall 2 unterhalb einer Schwelltemperatur für die thermische Oxidation zu halten. Es versteht sich, dass der Diamant-Kristall 2 nicht erst während des Einstrahlens des gepulsten Laserstrahls 4 auf eine Temperatur T in dem oben angegebenen Temperaturbereich aufgeheizt wird, sondern üblicherweise bereits vor dem Beginn des Laser-Ablationsverfahrens.

Wie in Fig. 1 durch einen Pfeil angedeutet ist, kann der Oberfläche 2a des Diamant-Kristalls 2 ein Fluid F zugeführt werden, welches im gezeigten Beispiel einen Gasstrom aus einem inerten Gas, z.B. Stickstoff, bildet. Der Gasstrom bzw. das Fluid F ist in Fig. 1 entgegen der Vorschubrichtung 12 ausgerichtet, um abgetragenes bzw. ablatiertes Material abzutransportieren. Der Gasstrom kann beispielsweise mit Hilfe einer an dem Laserbearbeitungskopf 5 angebrachten Düse erzeugt werden.

Bei dem in Fig. 1 gezeigten Beispiel werden jeweils ca. siebzig Ablationsbahnen 13 in X-Richtung lateral versetzt, um einen jeweiligen Graben 10a-d zu bilden, von denen in Fig. 2 zwei benachbarte Ablationsbahnen 13 gezeigt sind. Der laterale Versatz zwischen zwei benachbarten Ablationsbahnen 13 beträgt im gezeigten Beispiel ca. 3 µm. Der gepulste Laserstahl 4 wird mittels einer nicht bildlich dargestellten, in dem Laserbearbeitungskopf 5 angeordneten Fokussiereinrichtung, beispielsweise in Form einer Fokussierlinse, auf den Diamant-Kristall 2 fokussiert, und zwar in einer Fokusebene E, die bei dem in Fig. 2 gezeigten Beispiel ungefähr mit der Oberfläche 2a des Diamant-Kristalls 2 übereinstimmt. Bei dem in Fig. 2 gezeigten Beispiel beträgt der (minimale) Fokusdurchmesser des Laserstrahls 4 ca. 17 µm.

Die Parameter des gepulsten Laserstrahls 4 sind für einen flächigen Abtrag des Materials des Diamant-Kristalls 2 optimiert. Es versteht sich aber, dass es ausreichend sein kann, wenn zur Bildung eines Grabens 10a-d der Laserstrahl 4 nur entlang einer einzigen Ablationsbahn 13 in Vorschubrichtung 12 bewegt wird. Um die Tiefe eines jeweiligen Grabens 10a-d zu vergrößern, kann der weiter oben beschriebene Vorgang des Abtragens von Material entlang von mehreren lateral versetzten Ablationsbahnen 13 ggf. mehrfach wiederholt werden, so dass die Ablationsbahnen 13 vertikal übereinander liegen. Auf diese Weise kann ein jeweiliger Graben 10a-d mit einer gewünschten Breite und Tiefe erzeugt werden.

Um die in Fig. 2 gezeigte Seitenwand 11b des zweiten Grabens 10b, welche die (rechte) Seitenwand des ersten Stegwellenleiters 8a bildet, zu glätten, werden der Diamant-Kristall 2 und der Laserstrahl 4 mehrmals, z.B. mindestens fünf Mal, entlang ein- und derselben Ablationsbahn 13 in Vorschubrichtung 12 zueinander bewegt. Hierbei können die Laserparameter, beispielsweise die Pulsdauer τ, die Vorschubgeschwindigkeit, die (durchschnittliche) Leistung, etc. beim ersten Abfahren der Ablationsbahn 13 sich von den Laserparametern unterscheiden, die beim zweiten, dritten, ... Abfahren der Ablationsbahn 13 verwendet werden: Die Laserparameter beim ersten Abfahren der Ablationsbahn 13 sind hierbei für den flächigen Abtrag optimiert, während die Laserparameter beim zweiten, dritten, ... Abfahren der Ablationsbahn 13 für das Glätten der Seitenwand 11b des Stegwellenleiters 8a optimiert sind. Alternativ oder zusätzlich kann eine Glättung der Seitenwände 11a, 11b auch auf andere Weise erfolgen, wie dies weiter unten näher beschrieben ist.

Wie in Fig. 2 zu erkennen ist, verlaufen die Seitenwände 11a,b des Stegwellenleiters 8a, der auf die weiter oben beschriebene Weise hergestellt wurde, nicht exakt senkrecht zur Oberfläche 2a des optischen Kristalls 2, sondern sind geringfügig zur Vertikalen bzw. zur Normalenrichtung 14 der Oberfläche 2a des optischen Kristalls 2 geneigt.

Um Stegwellenleiter 8a-c mit möglichst steilen Seitenflächen 11a,b zu erzeugen, wie sie in Fig. 1 dargestellt sind, hat es sich als günstig erwiesen, bei der Ablation bzw. beim Bewegen des gepulsten Laserstrahls 4 und des Diamant-Kristalls 2 relativ zueinander die Strahlachse 6 des Laserstrahls 4 unter einem Winkel θ gegenüber der Normalenrichtung 15 der Oberfläche 2a des Diamant-Kristalls 2 zu verkippen, und zwar im gezeigten Beispiel quer zur Vorschubrichtung 12, d.h. in der XZ-Ebene.

Um dies zu erreichen, kann der Laserbearbeitungskopf 5 eine Scannereinrichtung 15 aufweisen, die es ermöglicht, einen (Scan-)Winkel θ einzustellen, unter dem der Laserstrahl 4 aus dem Laserbearbeitungskopf 5 austritt, wie dies beispielhaft in **Fig. 3** dargestellt ist. Die Scannereinrichtung 16 (Trepaniersystem) weist in der Regel zwei unabhängig voneinander verkippbare Scanner-Spiegel, einen um zwei Drehachsen drehbaren Scanner-Spiegel oder eine Kombination aus einem Polygonscanner und einem drehbaren Spiegelscanner bzw. Scanner-Spiegel auf, um den Scanwinkel θ nicht nur in der XZ-Ebene einstellen zu können, wie dies in Fig. 3 dargestellt ist, sondern den Laserstrahl 4 beim Austritt aus dem Laserbearbeitungskopf 5 beliebig zu orientieren bzw. auszurichten. Die Scannereinrichtung 16 kann beispielsweise einen Polygonscanner aufweisen, um den Laserstrahl 4 in der YZ-Ebene zur Bildung der Gräben 10a-d entlang der Vorschubrichtung 12 abzulenken. In diesem Fall ist es günstig, wenn in dem Laserbearbeitungskopf 5 eine Fokussiereinrichtung in Form einer telezentrischen Planfeldoptik angeordnet ist, um den Laserstrahl 4 nach der Ablenkung auf den Diamant-Kristall 2 zu fokussieren.

Durch die Möglichkeit, den Diamant-Kristall 2 mit Hilfe der Translations-Plattform 7 in X-Richtung und Y-Richtung zu verschieben, kann für jede Orientierung der Vorschubrichtung 12 in der XY-Ebene der Scanwinkel θ unabhängig von dem Ort eingestellt werden, an dem der Laserstrahl 4 auf der Oberfläche 2a des optischen Kristalls 2 auftrifft. Dies ist günstig, da der Scanwinkel θ, unter dem die Strahlachse 6 des Laserstrahls 4 relativ zur Normalenrichtung 14 der Oberfläche 2a des optischen Kristalls 2 ausgerichtet ist, in der Regel in einer Ebene senkrecht zur Vorschubrichtung 12 ausgerichtet werden sollte, wie weiter unten näher beschrieben ist. In Fig. 3 sind beispielhaft zwei Scanwinkel -θ, + θ gezeigt, unter denen die Strahlachse 6 des Laserstrahls 4 in der XZ-Ebene relativ zur Normalenrichtung 15 ausgerichtet werden kann.

Zur Ausrichtung des Laserstrahls 4 unter einem Winkel θ zur Normalenrichtung 15 des Diamant-Kristalls 2 bestehen auch andere Möglichkeiten. Beispielsweise kann eine Plattform, auf welcher der Diamant-Kristall 2 gelagert ist, unter einem Winkel zur horizontalen Ebene (XY-Ebene) verkippt werden, wie dies im Detail in der DE 10 2019 214 684 A1 beschrieben ist.

Um die in Fig. 1 gezeigten Wellenleiter 8a-c mit möglichst steil ansteigenden Seitenflächen 11a,b zu erzeugen, kann die in Zusammenhang mit Fig. 1 beschriebene Ablation von Material zur Herstellung der Gräben 10a-d durchgeführt werden. Im Gegensatz zu dem oben beschriebenen Verfahren wird die Strahlachse 6 des Laserstrahls 4 während des Bildens eines jeweiligen Grabens 10a-d zumindest entlang von Ablationsbahnen 13, die benachbart zu einer Seitenwand 11a,b eines jeweiligen Stegwellenleiters 8a, 8b, ... verlaufen, unter einem Winkel -θ, +θ zur Normalenrichtung 14 der Oberfläche 2a des optischen Kristalls 2 verkippt, der von der jeweiligen Seitenwand 11a,b weg geneigt ist, wie dies ebenfalls in der DE 10 2019 214 684 A1 beschrieben ist. Um möglichst steile, senkrecht zur Oberfläche 2a des optischen Kristalls 2 ausgerichtete Seitenwände 11a,b zu erzeugen, hat es sich als günstig erwiesen, wenn der Winkel θ zwischen 2° und 60°, bevorzugt zwischen 10° und 45°, insbesondere zwischen 15° und 30° liegt.

Wie in Fig. 3 ebenfalls zu erkennen ist, sind der Diamant-Kristall 2 und die Temperier-Einrichtung 14 in Form des Suszeptors in einer gasdicht gegen die Umgebung abgedichteten Prozesskammer 17 angeordnet. Auf die Darstellung der Translationsplattform 7 wurde in Fig. 3 aus Gründen der Übersichtlichkeit verzichtet. Zur Einstrahlung des Laserstrahls 4 weist die Prozesskammer 17 ein für die Laserwellenlänge λ_{L} transparentes Fenster 18 auf, das im gezeigten Beispiel aus Quarzglas besteht. In der Prozesskammer 17 herrscht eine Restgas-Atmosphäre mit einem Gesamtdruck p in der Größenordnung von ca. 10 mbar bis ca. 100 mbar. Der Gesamtdruck p kann mit Hilfe einer Vakuum-Pumpe 19 eingestellt bzw. die Prozesskammer 17 kann mit Hilfe der Vakuum-Pumpe 19 evakuiert werden. Nach dem Evakuieren wird der Innenraum der Prozesskammer 17 mit Hilfe eines ersten Ventils 20a von der Vakuum-Pumpe 19 getrennt. Der Gesamtdruck p in der Prozesskammer 17 wird mit Hilfe eines Druckmessgeräts 21 überwacht. Erforderlichenfalls kann eine in der Vorrichtung 1 vorgesehene Steuerungseinrichtung auf die Vakuum-Pumpe 19 einwirken, um den Gesamtdruck p in der Prozesskammer 17 auf einen vorgegebenen Soll-Wert zu regeln.

Über ein zweites und drittes Ventil 20b, 20c wird eine Mischung aus einem reaktiven Gas, im gezeigten Beispiel in Form von Sauerstoff O₂, und einem Inertgas, im gezeigten Beispiel in Form von Stickstoff N₂, in den Innenraum der Prozesskammer 17 eingeleitet. Die Partialdrücke von Sauerstoff O₂ und von Stickstoff N₂ in der Prozesskammer 17 liegen in der Größenordnung von ca. 10:1 bis 100:1.

Bei den drei Ventilen 20a-c handelt es sich um Absperr-Ventile, die ebenfalls mit Hilfe einer Steuerungseinrichtung angesteuert werden können, um den Partialdruck bzw. die Konzentration des Inertgases N₂ und des reaktiven Gases O₂ in dem Innenraum der Prozesskammer 17 einzustellen. Grundsätzlich kann mit Hilfe der beiden Ventile 20b,c ein beliebiges Mischungsverhältnis des Inertgases N₂ und des reaktiven Gases O₂ in der Prozesskammer 17 eingestellt werden. Mit Hilfe des reaktiven Gases O₂ kann die Wirkung des eingestrahlten gepulsten Laserstrahls 4 verstärkt werden. Das Inertgas N₂ stellt sicher, dass es nicht zu einem ungewollten Abbrennen des Diamant-Materials kommt.

Durch die zusätzliche Temperatureinwirkung auf den Diamant-Kristall 2 können bei dem weiter oben beschriebenen Verfahren die Pulsenergien des gepulsten Laserstrahls 4, der für die Laserablation verwendet wird, reduziert werden. Es ist möglich, aber nicht zwingend erforderlich, die Temperatur T des Diamant-Kristalls 2 konstant zu halten oder einen vorgegebenen zeitlichen Verlauf der Temperatur T einzustellen. In der Regel stellt sich bei einer konstanten Heizleistung der Temperier-Einrichtung 14, beispielsweise bei einem vorgegebenen Strom der WiderstandsHeizung, die für die Heizung des Suszeptors verwendet wird, ein Temperatur-Gleichgewicht in der Prozesskammer 17 ein, so dass auf eine Regelung bzw. Überwachung der Temperatur T verzichtet werden kann.

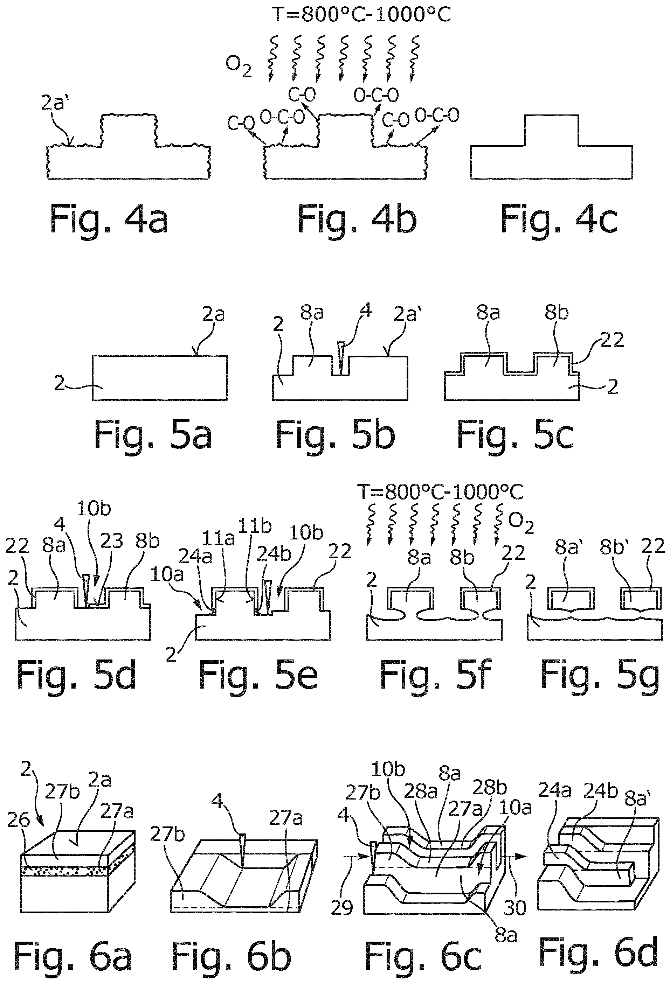

Die Anordnung des Diamant-Kristalls 2 in der Prozesskammer 17 ermöglicht es, eine Glättung der strukturierten Oberfläche 2a' nach dem Materialabtrag durchzuführen, wie dies nachfolgend anhand von **Fig. 4a****-c** beschrieben wird. Für die Glättung wird eine kontrollierte thermische Oxidation der strukturierten Oberfläche 2a' bei einer Temperatur zwischen 600°C und 1100°C, z.B. zwischen 650°C und 1000°C, typischerweise zwischen 800°C und 1000°C, in einer Sauerstoff O₂ enthaltenden Atmosphäre in dem Innenraum der Prozesskammer 17 durchgeführt. Hierbei wird der Kohlenstoff des Diamant-Kristalls 2 oxidiert, wie dies in Fig. 4b angedeutet ist. Die thermische Oxidation wird über eine vergleichsweise geringe Zeitdauer durchgeführt, die in der Regel zwischen wenigen Sekunden und einer Minute liegt. Die Prozessparameter, insbesondere die Temperatur T, der Druck p, der Partialdruck des Sauerstoffs O₂ und die Zeitdauer der thermischen Oxidation in der Prozesskammer 17 werden hierbei gezielt eingestellt, um Rauigkeiten zu minimieren, ohne dass es zu einem (signifikanten) Materialabtrag kommt.

Nachfolgend wird anhand von **Fig. 5a****-f** beschrieben, wie aus den in Fig. 1 gezeigten Mikrostrukturen 8a-c freistehende Mikrostrukturen 8a'-8c' gebildet werden.

Fig. 5a zeigt den Diamant-Kristall 2 mit einer planen Oberfläche 2a, auf die der gepulste Laserstrahl 4 eingestrahlt wird, um Material von dem Diamant-Kristall 2 abzutragen, wie dies in Fig. 5b angedeutet ist, um auf die in Zusammenhang mit Fig. 1 beschriebene Weise die Stegwellenleiter 8a-c zu erzeugen.

Fig. 5c zeigt eine auf die strukturierte Oberfläche 2a' abgeschiedene Maskierungsschicht 22, die dazu dient, die strukturierte Oberfläche 2a' vor einem nachfolgenden Ätzangriff zu schützen. Wie in Fig. 5c zu erkennen ist, ist die Maskierungsschicht 22 homogen auf der strukturierten Oberfläche 2a' abgeschieden und weist eine im Wesentlichen konstante Dicke auf, die in der Größenordnung zwischen ca. 10 nm und ca. 1000 nm, idealerweise zwischen 200 nm und 300 nm, liegt. Um eine solche konformale, möglichst homogene Abscheidung der Maskierungsschicht 22 auf die strukturierte Oberfläche zu ermöglichen, erfolgt das Abscheiden der Maskierungsschicht 22 typischerweise durch einen CVD-Prozess oder durch einen ALD-Prozess. Bei dem Material der Maskierungsschicht 22 handelt es sich um ein temperaturstabiles Nitrid oder Oxid, beispielsweise SiO₂, Al₂O₃, SiN, oder um ein anderes amorphes, temperaturstabiles Oxid oder Nitrid wie TiO bzw. TiO₂, ZrO, TiN, AIN oder dergleichen. Die Abscheidung der Maskierungsschicht 22 erfolgt typischerweise nicht in der in Fig. 3 gezeigten Prozesskammer, sondern in einer speziell für die Abscheidung von Schichten vorgesehenen Beschichtungsanlage, z.B. in einem so genannten CVD-Reaktor.

Wie in Fig. 5d beispielhaft für den zweiten Graben 10b gezeigt ist, wird die Maskierungsschicht 22 am Boden 23 der jeweiligen Gräben 10a-d entfernt. Bei dem in Fig. 5d gezeigten Beispiel wird die Maskierungsschicht 22 über die gesamte Breite des Bodens 23 entfernt bzw. abgetragen, der sich zwischen den beiden Stegwellenleitern 8a,b erstreckt. Es ist grundsätzlich möglich, dass die Maskierungsschicht 22 nur im Bereich der Seitenwände 11a,b und nicht über die gesamte Breite des Bodens 23 eines jeweiligen Grabens 10a-d abgetragen wird.

In Längsrichtung der Gräben 10a-d (d.h. in Y-Richtung) wird die Maskierungsschicht 22 nur in einem Abschnitt entfernt, in dem die in Fig. 3 dargestellten freistehenden Stegwellenleiter 8a'-8c' gebildet werden sollen. In einem Bereich in Längsrichtung vor und hinter dem Bereich, in dem die freistehenden Stegwellenleiter 8a'-8c' gebildet werden sollen (in Fig. 3 durch gestrichelte Linien angedeutet), wird die Maskierungsschicht 22 am Boden 23 der jeweiligen Gräben 10a-d nicht abgetragen.

Für das lokale Entfernen der Maskierungsschicht 22 wird im gezeigten Beispiel der in Zusammenhang mit Fig. 1 bis Fig. 3 beschriebene gepulste Laserstrahl 4 verwendet. Zu diesem Zweck kann aber auch ein Laserstrahl verwendet werden, der eine andere Wellenlänge aufweist. Auch kann die für die Entfernung der Maskierungsschicht 22 verwendete Pulsdauer von den weiter oben in Zusammenhang mit dem Materialabtrag beschriebenen Pulsdauern abweichen. Die teilweise Entfernung der Maskierungsschicht 22 kann auch durch einen so genannten Lift-Off Prozess erfolgen, bei der ein. Photoresist lithografisch so strukturiert wird, dass dieser nur im Bereich des Bodens 23 der jeweiligen Gräben 10a-d bzw. in einem Abschnitt verbleibt, in dem die Stegwellenleiter 8a'-8c' gebildet werden sollen. Nach ganzflächiger Abscheidung der Maskierungsschicht 22 wird der verbliebene Photoresist z. B. durch einen Lösemittelangriff entfernt, wodurch gleichzeitig auch die auf dem verbliebenen Photoresist vorhandene Maskierungsschicht 22 abgelöst wird.

Wie in Fig. 5e zu erkennen ist, wird nach dem Entfernen der Maskierungsschicht 22 vom Boden eines jeweiligen Grabens 10a-d der Graben 10a-d durch zusätzliches Abtragen von Material des Diamant-Kristalls 2 vertieft. Das Vertiefen eines jeweiligen Grabens 10a-d erfolgt zumindest entlang der beiden Seitenwände 11a,b eines jeweiligen Wellenleiters 8a, um einen die Seitenwände 11a,b verlängernden Abschnitt 24a,b zu bilden, der nicht von der Maskierungsschicht 22 bedeckt ist.

Um die freistehenden Wellenleiterstrukturen 8a'-8c' zu bilden, werden die in Fig. 5e gezeigten Wellenleiterstrukturen 8a-c in einem isotropen Ätzprozess unterätzt, wie dies in Fig. 5f angedeutet ist. Hierbei wird ausgenutzt, dass die nicht von der Maskierungsschicht 22 bedeckten Abschnitte 24a,b der Seitenwände 11a,b nicht vor einem Ätzangriff geschützt sind, so dass das Material des Diamant-Kristalls 2 unterhalb des Wellenleiters 8a-c vollständig abgetragen werden kann und der freistehende Wellenleiter 8a'-8c' gebildet wird, wie dies in Fig. 5g dargestellt ist.

Das Unterätzen der Wellenleiterstrukturen 8a-c erfolgt durch thermische Oxidation des Diamant-Kristalls 2 bei einer Temperatur T zwischen 600°C und 1100°, typischerweise zwischen 800°C und 1000°C, in einer Sauerstoff O₂ enthaltenden Atmosphäre, die im gezeigten Beispiel in der Prozesskammer 17 herrscht, in die der mit der Maskierungsschicht 22 versehene Diamant-Kristall 2 eingebracht ist. Bei der thermischen Oxidation handelt es sich um einen isotropen Ätzprozess, bei dem nur die nicht von der Maskierungsschicht 22 bedeckten Bereiche der Oberfläche des Diamant-Kristalls 2 angegriffen werden. Die Prozessdauer der thermischen Oxidation richtet sich nach der Ätzgeschwindigkeit, die bei den jeweils eingestellten Prozessparametern (Temperatur T, Druck p, Gehalt bzw. Partialdruck des Sauerstoffs O₂ in der Umgebung, etc.) in der Prozesskammer 17 vorherrscht und kann von wenigen Sekunden bis zu mehreren Minuten betragen.

Es kann günstig sein, für das Unterätzen ein Sauerstoff-Plasma zu erzeugen, wie dies z.B. in einem CVD-Reaktor der Fall ist. Durch das Sauerstoff-Plasma wird die Reaktivität des Sauerstoffs O₂ erhöht und die für die thermische Oxidation benötigte Temperatur T kann reduziert werden. Das Sauerstoff-Plasma kann mit Hilfe einer Plasmaerzeugungseinrichtung in der in Fig. 3 gezeigten Prozesskammer 17 erzeugt werden, es ist aber auch möglich, dass der Diamant-Kristall 2 in eine speziell zu diesem Zweck vorgesehene Vorrichtung, beispielsweise in eine Plasma-Ätzanlage, überführt wird. Nach dem Freistellen der Wellenleiterstrukturen 8a'-8c' wird die Maskierungsschicht 22 typischerweise vollständig von der strukturierten Oberfläche 2a' entfernt.

Die freistehenden Wellenleiterstrukturen 8a'-8c' sind an den restlichen Diamant-Kristall 2 über weitere (erste und zweite) Wellenleiterstrukturen 24a-c, 25a-c angebunden, die sich in Längsrichtung der Gräben 10a-c an die freistehenden Wellenleiterstrukturen 8a'-8c' anschließen, wie dies in Fig. 3 dargestellt ist. Die weiteren ersten Wellenleiterstrukturen 24a-c schließen an einer ersten, in Fig. 3 vorderen Seite an die freistehenden Wellenleiterstrukturen 8a'-8c' an, während die weiteren zweiten Wellenleiterstrukturen 25a-c sich an einer zweiten, in Fig. 3 hinteren Seite an die freistehenden Wellenleiterstrukturen 8a'-8c' anschließen. Die weiteren ersten Wellenleiterstrukturen 24a-c dienen zur Zuführung von Licht zu den freistehenden Wellenleiterstrukturen 8a'-8c' und die weiteren zweiten Wellenleiterstrukturen 25a-c dienen zur Abführung von Licht von den freistehenden Wellenleiterstrukturen 8a'-8c'. Die freistehenden Wellenleiterstrukturen 8a'-8c' ermöglichen ein Confinement der in diesen geführten Moden auch in vertikaler Richtung. Insbesondere kann durch eine Variation der Tiefe der Gräben bei der Strukturierung der Oberfläche 2a des Diamant-Kristalls 2 auch eine Variation der Höhe des jeweiligen freistehenden Wellenleiters 8a'-8c' erfolgen.

Für den Fall, dass der Diamant-Kristall 2 im Bereich der freistehenden Wellenleiterstrukturen 8a'-8c' mit Farbzentren, beispielsweise mit NV-Zentren, dotiert ist, können die freistehenden Wellenleiterstrukturen 8a'-8c' als räumlich präzise definierte Messbereiche z.B. zur Magnetfeldmessung eingesetzt werden. In diesem Fall ist es günstig, wenn die weiteren Wellenleiterstrukturen 24a-c, 25a-c, die an die freistehenden Wellenleiterstrukturen 8a'-8c' angrenzen, nicht mit NV-Zentren dotiert sind. Um einen auf diese Weise strukturierten Diamant-Kristall 2 zu erzeugen, kann auf eine Weise vorgegangen werden, die nachfolgend in Zusammenhang mit **Fig. 6a****-d** beschrieben wird.

Der zu strukturierende Diamant-Kristall 2 weist in diesem Fall zwei aneinander angrenzende Schichten 27a, 27b auf, von denen die erste Schicht 27a von der zu strukturierenden Oberfläche 2a beabstandet ist und von denen die zweite Schicht 27b unmittelbar an die zu strukturierende Oberfläche 2a angrenzt (vgl. Fig. 6a). Bei der ersten Schicht 27a handelt es sich um eine vergrabene Schicht, in welcher der Diamant-Kristall 2 mit NV-Zentren dotiert ist, während der Diamant-Kristall 2 sowohl in der zweiten Schicht 27b als auch unterhalb der ersten Schicht 27a nicht mit NV-Zentren dotiert ist. Die Konzentration der NV-Zentren in der ersten Schicht 27a liegt typischerweise zwischen ca. 0,1 ppm und 2 ppm, beispielsweise zwischen 0,3 ppm und 0,7 ppm, insbesondere bei ca. 0,5 ppm.

Für die Bildung der freistehenden Wellenleiter 8a'-8c' in der ersten Schicht 27a wird zunächst die Oberfläche 2a des Diamant-Kristalls 2 mittels Laserablation strukturiert, wie dies weiter oben in Zusammenhang mit Fig. 1 beschrieben wurde. Bei der Laserablation wird in einem ersten, in Fig. 6b dargestellten Schritt die zweite Schicht 27b in einem Teilbereich abgetragen, der oberhalb der jeweiligen zu bildenden Wellenleiterstrukturen 8a-c liegt. Wie in Fig. 6b dargestellt ist, wird hierbei auch Material der zweiten Schicht 27b abgetragen, das zwischen den zu bildenden Wellenleiterstrukturen 8a-c liegt. In zwei sich an den vollständig abgetragenen Teilbereich anschließenden Übergangsbereichen, an denen später die weiteren Wellenleiterstrukturen 24a-c, 25a-c an die freistehenden Wellenleiterstrukturen 8a'-8c' angrenzen, wird die zweite Schicht 27b teilweise abgetragen.

In einem nachfolgenden Schritt wird der Diamant-Kristall 2 wie weiter oben in Zusammenhang mit Fig. 1 beschrieben wurde strukturiert, indem Gräben 10a,b in dem Diamant-Kristall 2 gebildet werden um die Wellenleiterstrukturen 8a-c sowie um die weiteren Wellenleiterstrukturen 24a-c, 25a-c zu bilden. Die Gräben 10a,b erstrechen sich im Bereich der Wellenleiterstrukturen 8a-c bis in die erste Schicht 27a und sind im Bereich der weiteren Wellenleiterstrukturen 24a-c, 25a-c auf die zweite Schicht 27b begrenzt. Die Grenzfläche zwischen der ersten Schicht 27a und der zweiten Schicht 27b ist in Fig. 6b-d gestrichelt angedeutet.

Nach den nicht bildlich dargestellten Schritten des Aufbringens der Maskierungsschicht 22, des teilweisen Entfernens der Maskierungsschicht 22 sowie des Vertiefens der Gräben 10a,b zum Freilegen der jeweiligen nicht von der Maskierungsschicht 22 bedecken Abschnitte der Seitenwände 10a,b, die auf die in Zusammenhang mit Fig. 5c-e beschriebene Weise erfolgen, wird auf die in Zusammenhang mit Fig. 5g beschriebene Weise ein Unterätzen der Wellenleiterstrukturen 8a-c durgeführt, um die freistehenden Wellenleiterstrukturen 8a'-8c' zu bilden, von denen in Fig. 6d beispielhaft eine Wellenleiterstruktur 8a' dargestellt ist.

Wie in Fig. 6c angedeutet ist, kann über die weiteren ersten Wellenleiterstrukturen 24a-c, die in der nicht dotierten zweiten Schicht 27b gebildet werden, den freistehenden Wellenleiterstrukturen 8a'-8'c Anregungslicht 29 zugeführt werden, das mit den NV-Zentren 26 in der ersten Schicht 27a wechselwirkt. Das hierbei gebildete Fluoreszenzlicht 30 kann mit Hilfe der weiteren zweiten Wellenleiterstrukturen 25a-c gesammelt und von den freistehenden Wellenleiterstrukturen 8a'-8c' abgeführt und beispielsweise einem Detektor oder dergleichen zugeführt werden. Die Ein- und Auskopplung kann an den Stirnseiten bzw. an den Kanten der weiteren Wellenleiterstrukturen 24a-c, 25a-c mit Hilfe von geeigneten Einkoppeleinrichtungen bzw. von Auskoppeleinrichtungen erfolgen, bei denen es sich um die Endfacetten der weiteren Wellenleiterstrukturen 24a-c, 25a-c, um Gitterkoppler, etc. handeln kann.

Es versteht sich, dass die freistehenden Wellenleiterstrukturen 8a'-8c' nicht zwingend einen rechteckigen, in Längsrichtung der freistehenden Wellenleiterstrukturen 8a'-8c' konstanten Querschnitt aufweisen müssen. Für viele Anwendungen kann es günstig sein, wenn der Querschnitt eines jeweiligen freistehenden Wellenleiters 8a'-8c' in Längsrichtung variiert. Beispielsweise kann es bei der weiter oben beschriebenen Anwendung zur Magnetfeldmessung günstig sein, zur Optimierung der Anregungsdichte des Anregungslichts 29 die Geometrie der jeweiligen freistehenden Wellenleiter 8a'-8c' geeignet anzupassen. Beispielsweise kann der Querschnitt der freistehenden Wellenleiterstruktur 8a'-8c' in Propagationsrichtung des Anregungslichts 29 abnehmen, um die Anregungsdichte in Längsrichtung möglichst konstant zu halten. Die Abnahme des Querschnitts kann durch eine sich verjüngende, kegelstumpfartige bzw. keilförmige Geometrie der jeweiligen freistehenden Wellenleiterstruktur 8a'-8c' erreicht werden.

## Patentansprüche

1. Verfahren zum Bilden mindestens einer freistehenden Mikrostruktur, insbesondere einer freistehenden Wellenleiterstruktur (8a'-8c'), an einem Diamant-Kristall (2), umfassend:
Strukturieren einer Oberfläche (2a) des Diamant-Kristalls (2) durch Abtragen von Material zur Ausbildung von mindestens zwei Gräben (10a,b), deren benachbarte Seitenwände (11a,b) die Seitenwände (11a,b) einer Mikrostruktur, insbesondere einer Wellenleiterstruktur (8a-8c), bilden,
Abscheiden mindestens einer Maskierungsschicht (22) auf die strukturierte Oberfläche (2a'),
Zumindest teilweises Entfernen der Maskierungsschicht (22) vom Boden (23) der Gräben (10a,b),
Vertiefen der Gräben (10a,b) durch zusätzliches Abtragen von Material des Diamant-Kristalls (2) zumindest entlang der Seitenwände (11a,b), sowie Bilden der freistehenden Mikrostruktur, insbesondere der freistehenden Wellenleiterstruktur (8a'-8c'), durch Unterätzen der Mikrostruktur, insbesondere der Wellenleiterstruktur (8a-c).

2. Verfahren nach Anspruch 1, bei dem das Unterätzen der Mikrostruktur,
insbesondere der Wellenleiterstruktur (8a-c), durch eine thermische Oxidation des Diamant-Kristalls (2) bei einer Temperatur (T) zwischen 600°C und 1100°C bevorzugt in einer Sauerstoff (O₂) enthaltenden Atmosphäre, insbesondere in einem Sauerstoff-Plasma, erfolgt.

3. Verfahren nach Anspruch 1 oder 2, bei dem zum Glätten der strukturierten Oberfläche (2a) eine thermische Oxidation der strukturierten Oberfläche (2a) bei einer Temperatur (T) zwischen 600°C und 1100°C, bevorzugt in einer Sauerstoff (O₂) enthaltenden Atmosphäre, insbesondere in einem Sauerstoff-Plasma, durchgeführt wird.

4. Verfahren nach einem der vorhergehenden Ansprüche, bei dem das Abscheiden der mindestens einen Maskierungsschicht (22) durch chemisches Gasphasenabscheiden oder durch Atomlagenabscheiden erfolgt.

5. Verfahren nach einem der vorhergehenden Ansprüche, bei dem das Abtragen des Materials, das zumindest teilweise Entfernen der Maskierungsschicht (22) und/oder das zusätzliche Abtragen des Materials durch Laserablation mittels eines bevorzugt gepulsten Laserstrahls (4) erfolgt.

6. Verfahren nach Anspruch 5, bei dem eine Temperatur (T) des Diamant-Kristalls (2) beim Abtragen des Materials, beim zumindest teilweisen Entfernen der Maskierungsschicht (22) und/oder beim zusätzlichen Abtragen des Materials bei mehr als 600°C, bevorzugt bei mehr als 700°C, insbesondere bei mehr als 800°C und bei weniger als 1000°C liegt.

7. Verfahren nach Anspruch 5 oder 6, bei dem das Abtragen des Materials umfasst:
Einstrahlen des gepulsten Laserstrahls (4) auf die Oberfläche (2a) des Diamant-Kristalls (2),
Bewegen des gepulsten Laserstrahls (4) und des Diamant-Kristalls (2) relativ zueinander entlang einer Vorschubrichtung (12) entlang mindestens einer Ablationsbahn (13), wobei bevorzugt zum Bilden der Gräben (10a-d) der Laserstrahl (4) und der Diamant-Kristall (2) relativ zueinander mehrfach entlang von lateral versetzten Ablationsbahnen (13) bewegt werden.

8. Verfahren nach einem der Ansprüche 5 bis 7, bei dem der gepulste Laserstrahl mit einer Wellenlänge (λ_{L}) von weniger als 450 nm auf die Oberfläche (2a) des Diamant-Kristalls (2) eingestrahlt wird.

9. Verfahren nach einem der vorhergehenden Ansprüche, bei dem der Diamant-Kristall (2) beim Unterätzen, beim Abtragen von Material, beim zusätzlichen Abtragen von Material und/oder beim Glätten der strukturierten Oberfläche (2a) bevorzugt gemeinsam mit einer Temperier-Einrichtung (14) in einer gasdichten Prozesskammer (17) angeordnet wird.

10. Verfahren nach einem der vorhergehenden Ansprüche, bei dem der Diamant-Kristall (2) im Bereich der freistehenden Mikrostruktur, insbesondere der freistehenden Wellenleiterstruktur (8a'-8c'), mit Farbzentren, bevorzugt mit NV-Zentren (26), dotiert ist.

11. Verfahren nach einem der vorhergehenden Ansprüche, weiter umfassend:
Bilden mindestens einer weiteren Mikrostruktur, bevorzugt mindestens einer weiteren Wellenleiterstruktur (24a-c, 25a-c), in dem Diamant-Kristall (2), die insbesondere zur Zuführung von Anregungslicht (29) zu der freistehenden Wellenleiterstruktur (8a') und/oder zur Abführung von Fluoreszenzlicht (30) von der freistehenden Wellenleiterstruktur (8a') dient, wobei der Diamant-Kristall (2) im Bereich der mindestens einen weiteren Mikrostruktur, bevorzugt der mindestens einen weiteren Wellenleiterstruktur (24a-c, 25a-c), bevorzugt nicht mit Farbzentren, insbesondere nicht mit NV-Zentren (26), dotiert ist.

12. Verfahren nach Anspruch 11, bei dem der der Diamant-Kristall (2) eine erste Schicht (27a) umfasst, die mit den Farbzentren, bevorzugt mit den NV-Zentren (26), dotiert ist, und bei dem der Diamant-Kristall (2) eine zweite Schicht (27b) umfasst, die an die erste Schicht (27a) angrenzt und die nicht mit den Farbzentren, bevorzugt nicht mit den NV-Zentren (26), dotiert ist, wobei in der ersten Schicht (27a) die freistehenden Mikrostrukturen, bevorzugt die freistehenden Wellenleiterstrukturen (8a'-8'), gebildet werden, und wobei in der zweiten Schicht (27b), die bevorzugt an die Oberfläche (2a) des Diamant-Kristalls (2) angrenzt, die weiteren Mikrostrukturen, bevorzugt die weiteren Wellenleiterstrukturen (24a-c, 25a-c), gebildet werden.

13. Verfahren nach Anspruch 12, bei dem das Strukturieren der Oberfläche (2a) das Abtragen des Materials der zweiten Schicht (27b) oberhalb der zu bildenden Mikrostruktur, bevorzugt der zu bildenden Wellenleiterstruktur (8a-c), zum Freilegen einer Oberseite (28a-c) der zu bildenden Mikrostruktur, bevorzugt der zu bildenden Wellenleiterstruktur (8a-c), umfasst.

## Claims

1. Method for forming at least one free-standing microstructure, in particular a free-standing waveguide structure (8a'-8c'), on a diamond crystal (2), comprising:
structuring a surface (2a) of the diamond crystal (2) by removing material to form at least two trenches (10a,b), the adjacent side walls (11a,b) of which form the side walls (11a,b) of a microstructure, in particular a waveguide structure (8a-8c),
depositing at least one masking layer (22) onto the structured surface (2a'),
removing at least part of the masking layer (22) from the base (23) of the trenches (10a,b),
deepening the trenches (10a,b) by additionally removing material from the diamond crystal (2) at least along the side walls (11a,b), and
forming the free-standing microstructure, in particular the free-standing waveguide structure (8a'-8c'), by undercutting the microstructure, in particular the waveguide structure (8a-c).

2. Method according to claim 1, wherein the undercutting of the microstructure, in particular the waveguide structure (8a-c), is carried out by thermal oxidation of the diamond crystal (2) at a temperature (T) between 600°C and 1100°C, preferably in an oxygen (O₂)-containing atmosphere, in particular in an oxygen plasma.

3. Method according to claim 1 or 2, wherein, in order to smooth the structured surface (2a), a thermal oxidation of the structured surface (2a) is carried out at a temperature (T) between 600°C and 1100°C, preferably in an oxygen (O₂)-containing atmosphere, in particular in an oxygen plasma.

4. Method according to any of the preceding claims, wherein the deposition of the at least one masking layer (22) is carried out by chemical vapor deposition or by atomic layer deposition.

5. Method according to any of the preceding claims, wherein the removal of the material, the removal of at least part of the masking layer (22) and/or the additional removal of the material is carried out by laser ablation by means of a preferably pulsed laser beam (4).

6. Method according to claim 5, wherein a temperature (T) of the diamond crystal (2) during the removal of the material, during the removal of at least part of the masking layer (22) and/or during the additional removal of the material is more than 600°C, preferably more than 700°C, in particular more than 800°C and less than 1000°C.

7. Method according to claim 5 or 6, wherein the removal of the material comprises:
radiating the pulsed laser beam (4) onto the surface (2a) of the diamond crystal (2),
moving the pulsed laser beam (4) and the diamond crystal (2) relative to one another in a feed direction (12) along at least one ablation path (13), the laser beam (4) and the diamond crystal (2) preferably being moved relative to one another several times along laterally offset ablation paths (13) in order to form the trenches (10a-d).

8. Method according to any of claims 5 to 7, wherein the pulsed laser beam is radiated onto the surface (2a) of the diamond crystal (2) with a wavelength (λ_{L}) of less than 450 nm.

9. Method according to any of the preceding claims, wherein the diamond crystal (2) is arranged in a gas-tight process chamber (17), preferably together with a temper-control device (14), during undercutting, during removal of material, during additional removal of material and/or during smoothing of the structured surface (2a).

10. Method according to any of the preceding claims, wherein the diamond crystal (2) is doped with color centers, preferably with NV centers (26), in the region of the free-standing microstructure, in particular the free-standing waveguide structure (8a'-8c').

11. Method according to any of the preceding claims, further comprising:
forming at least one further microstructure, preferably at least one further waveguide structure (24a-c, 25a-c), in the diamond crystal (2), which is used in particular for supplying excitation light (29) to the free-standing waveguide structure (8a') and/or for removing fluorescent light (30) from the free-standing waveguide structure (8a'), the diamond crystal (2) preferably not being doped with color centers, in particular not with NV centers (26), in the region of the at least one further microstructure, preferably the at least one further waveguide structure (24a-c, 25a-c).

12. Method according to claim 11, wherein the diamond crystal (2) comprises a first layer (27a) which is doped with the color centers, preferably with the NV centers (26), and wherein the diamond crystal (2) comprises a second layer (27b) which borders the first layer (27a) and which is not doped with the color centers, preferably not with the NV centers (26), the free-standing microstructures, preferably the free-standing waveguide structures (8a'-8'), being formed in the first layer (27a), and the further microstructures, preferably the further waveguide structures (24a-c, 25a-c), being formed in the second layer (27b), which preferably borders the surface (2a) of the diamond crystal (2).

13. Method according to claim 12, wherein the structuring of the surface (2a) comprises removing the material of the second layer (27b) above the microstructure to be formed, preferably the waveguide structure (8a-c) to be formed, to expose an upper face (28a-c) of the microstructure to be formed, preferably the waveguide structure (8a-c) to be formed.

## Revendications

1. Procédé de formation d'au moins une microstructure auto-portante,
en particulier d'une structure de guide d'ondes (8a'-8c') autoportante, sur un cristal de diamant (2), comprenant :
la structuration d'une surface (2a) du cristal de diamant (2) par enlèvement de matière pour la réalisation d'au moins deux tranchées (10a, b) dont les parois latérales (11a, b) voisines forment les parois latérales (11a, b) d'une microstructure, en particulier d'une structure de guide d'ondes (8a-8c),
le dépôt d'au moins une couche de masquage (22) sur la surface (2a') structurée,
le retrait au moins partiel de la couche de masquage (22) du fond (23) des tranchées (10a, b),
l'évidement des tranchées (10a, b)
par enlèvement supplémentaire de matière du cristal de diamant (2) au moins le long des parois latérales (11a, b), et
la formation de la microstructure autoportante, en particulier de la
structure de guide d'ondes (8a'-8c') autoportante, par sous-gravure de la microstructure, en particulier de la structure de guide d'ondes (8a-c).

2. Procédé selon la revendication 1, selon lequel la sous-gravure de la microstructure,
en particulier de la structure de guide d'ondes (8a-c), s'effectue par une oxydation thermique du cristal de diamant (2) à une température (T) comprise entre 600 °C et 1100 °C, de préférence dans une atmosphère contenant de l'oxygène (O₂), en particulier dans un plasma d'oxygène.

3. Procédé selon la revendication 1 ou 2, selon lequel, pour le lissage de la surface
(2a) structurée, une oxydation thermique de la surface (2a) structurée est effectuée à une température (T) comprise entre 600 °C et 1100 °C, de préférence dans une atmosphère contenant de l'oxygène (O₂), en particulier dans un plasma d'oxygène.

4. Procédé selon l'une quelconque des revendications précédentes, selon lequel le dépôt de l'au moins une couche de masquage (22) est effectué par dépôt chimique en phase vapeur ou par dépôt par couche atomique.

5. Procédé selon l'une quelconque des revendications précédentes, selon lequel l'enlèvement de la matière, le retrait au moins partiel de la couche de masquage (22) et/ou l'enlèvement supplémentaire de la matière s'effectue par ablation au laser au moyen d'un faisceau laser (4) de préférence pulsé.

6. Procédé selon la revendication 5, selon lequel une température (T) du cristal de diamant (2) lors de l'enlèvement de la matière, lors du retrait au moins partiel de la couche de masquage (22) et/ou lors de l'enlèvement supplémentaire de la matière est supérieure à 600 °C, de préférence supérieure à 700 °C, en particulier supérieure à 800 °C et inférieure à 1000 °C.

7. Procédé selon la revendication 5 ou 6, selon lequel l'enlèvement de la matière comprend : la projection du faisceau laser (4) pulsé sur la surface (2a) du cristal de diamant (2), le déplacement du faisceau laser (4) pulsé et du cristal de diamant (2) l'un par rapport à l'autre le long d'une direction d'avance (12) le long d'au moins une trajectoire d'ablation (13), dans lequel de préférence pour former les tranchées (10a-d), le faisceau laser (4) et le cristal de diamant (2) sont déplacés l'un par rapport à l'autre plusieurs fois le long de trajectoires d'ablation (13) décalées latéralement.

8. Procédé selon l'une quelconque des revendications 5 à 7, selon lequel le faisceau laser pulsé est projeté sur la surface (2a) du cristal de diamant (2) avec une longueur d'onde (λ_{L}) inférieure à 450 nm.

9. Procédé selon l'une quelconque des revendications précédentes, selon lequel le cristal de diamant (2) est disposé dans une chambre de traitement (17) étanche aux gaz lors de la sous-gravure, lors de l'enlèvement de matière, lors de l'enlèvement supplémentaire de matière et/ou du lissage de la surface (2a) structurée, de préférence conjointement avec un dispositif de régulation de température (14).

10. Procédé selon l'une quelconque des revendications précédentes, selon lequel le cristal de diamant (2) est dopé avec des centres de couleur, de préférence avec des centres azote-lacune (26), dans la zone de la microstructure auto-portante, en particulier de la structure de guide d'ondes (8a'-8c') auto-portante.

11. Procédé selon l'une quelconque des revendications précédentes, comprenant en outre : la formation d'au moins une autre microstructure, de préférence d'au moins une autre structure de guide d'ondes (24a-c, 25a-c), dans le cristal de diamant (2), qui sert en particulier à amener de la lumière d'excitation (29) à la structure de guide d'ondes (8a') auto-portante et/ou à évacuer de la lumière fluorescente (30) de la structure de guide d'ondes (8a') auto-portante, dans lequel le cristal de diamant (2)
n'est de préférence pas dopée avec des centres de couleur, en particulier pas avec des centres azote-lacune (26) dans la zone de l'au moins une autre microstructure, de préférence l'au moins une autre structure de guide d'ondes (24a-c, 25a-c).

12. Procédé selon la revendication 11, selon lequel le cristal de diamant (2) comprend une première couche (27a) qui est dopée avec les centres de couleur, de préférence avec les centres azote-lacune (26), et selon lequel le cristal de diamant (2) comprend une deuxième couche (27b) qui est adjacente à la première couche (27a) et qui n'est pas dopée avec les centres de couleur, de préférence avec les centres azote-lacune (26), dans lequel les microstructures auto-portantes, de préférence les structures de guide d'ondes (8a'-8') auto-portantes, sont formées dans la première couche (27a), et les autres microstructures, de préférence les autres structures de guide d'ondes (24a-c, 25a-c), sont formées dans la deuxième couche (27b), qui est de préférence adjacente à la surface (2a) du cristal de diamant (2).

13. Procédé selon la revendication 12, selon lequel la structuration de la surface (2a) comprend l'enlèvement de la matière de la deuxième couche (27b) au-dessus de la microstructure à former, de préférence de la structure de guide d'ondes (8a-c) à former, pour mettre à nu une face supérieure (28a-c) de la microstructure à former, de préférence de la structure de guide d'ondes (8a-c) à former.
